# EUROPEAN PATENT APPLICATION

(11) **EP 4 397 720 A1**
(43) Date of publication of application: **10.07.2024**
(21) Application number: 22864318.5
(22) Date of filing: 22.08.2022
(51) Int. Cl.: C08L 83/07, C08J 5/00, C08K 3/013, C08K 5/544, C08L 83/05, C08L 91/06, H01L 23/29, H01L 23/31

(54) **CURABLE SILICONE COMPOSITION, CURED OBJECT THEREFROM, AND METHOD FOR PRODUCING SAID CURED OBJECT**

(30) Priority: 31.08.2021 JP 2021140800
(71) Applicant: Dow Toray Co., Ltd., Tokyo 140-8617 (JP)
(72) Inventor: YAMAZAKI Ryosuke, Ichihara-shi Chiba 299-0108 (JP); HAYASHI Masayuki, Ichihara-shi Chiba 299-0108 (JP); MATSUSHIMA Hidenori, Ichihara-shi Chiba 299-0108 (JP); OZAKI Koichi, Ichihara-shi Chiba 299-0108 (JP); IMAIZUMI Toru, Ichihara-shi Chiba 299-0108 (JP)
(74) Representative: Murgitroyd & Company
(86) International application number: PCT/JP2022/031578
(87) International publication number: WO 2023/032734

(57) **Abstract**

[Problem] To provide a curable silicone composition or the like having excellent handleability and curing properties during sealing due to good hot-melt properties and excellent melting properties, in addition to having excellent cured product mechanical strength and substrate bonding strength, making the composition suitable as a sealant for semiconductor devices. [Solution] Provided is a curable silicone composition comprising: (A) a hot-melt MDT-type organopolysiloxane resin having a specific siloxane unit ratio; (B) an organohydrogensiloxane compound; (C) a hydrosilylation catalyst; and (D) a functional inorganic filler in an amount of 400 to 3,000 parts by mass per 100 parts by mass of the total of components (A) to (C), wherein the curable silicone composition is solid at 25°C and has hot-melt properties at a temperature of 200°C or lower, along with the use thereof.

## Description

### TECHNICAL FIELD

The present invention relates to a curable silicone composition which has good hot melt properties and forms a cured product having excellent mechanical strength and bonding strength to a substrate. Further, the present invention relates to a cured product using the silicone composition, a molding method for the cured product, and a semiconductor device provided with the cured product.

### BACKGROUND ART

Curable silicone compositions are utilized in a wide range of industrial fields because they are cured to form cured products having excellent heat resistance, cold resistance, electrical insulation, weather resistance, water repellency, and transparency. In general, the cured product of such a curable silicone composition is also suitable as a sealant for optical materials and semiconductor devices because it is not readily discolored compared with other organic materials and there is less deterioration of physical properties. In contrast, in recent years, from the standpoint of handleability, hot-melt curable silicone compositions have been widely used as sealants for optical materials and semiconductor devices.

While epoxy-based sealants are generally used in the semiconductor device industry, epoxy-based materials are known to be inferior to silicone-based materials in terms of poorer heat resistance characteristics. At the same time, the mechanical strength of cured products obtained from silicone-based materials may be inferior to these of epoxy-based materials.

In the recent trend toward miniaturization and higher power semiconductor devices, the use of silicone-based sealants with excellent heat resistance has been expanding, with the present applicant having proposed, in Patent Documents 1 to 3, a hot-melt curable silicone composition for molding that contains a resinous silicone as a main component, which can be used for the abovementioned application. Similarly, Patent Document 4 discloses a hot-melt curable composition with a mixture of an organic skeleton and silicone components, while Patent Documents 5 and 6 disclose a white curable composition using a resinous silicone having a specific structure.

However, when these silicone-based curable compositions are used as a sealant, the mechanical strength of the cured product may be inferior to that of a cured product using an epoxy-based sealant, so there is a need for a hot-melt curable silicone composition that provides more excellent mechanical strength in addition to handling, workability, and cured product heat resistance.

### RELATED ART DOCUMENTS

### Patent Documents

Patent Document 1: WO 2018/030288
Patent Document 2: WO 2018/235491
Patent Document 3: JP 2001-19933 A
Patent Document 4: WO 2013/051600
Patent Document 5: JP 2015-74751 A
Patent Document 6: JP 2013-321075 A

### SUMMARY OF THE INVENTION

### PROBLEM TO BE SOLVED BY THE INVENTION

An object of the present invention is to provide a curable silicone composition having excellent handleability and curing properties during sealing due to good hot-melt properties and excellent melting properties, in addition to having excellent cured product mechanical strength and substrate bonding strength, making the composition suitable as a sealant for semiconductor devices. The present invention also provides a cured product obtained from this curable silicone composition, a member for a semiconductor device composed of this cured product, a semiconductor device having this cured product, and a molding method of this cured product.

### MEANS FOR SOLVING THE PROBLEM

As a result of intensive studies, the inventors of the present invention have found that the abovementioned problem can be solved by a hot-melt curable silicone composition containing as a primary component a hot-melt organopolysiloxane resin composed of the specific siloxane unit described below and having a high functional inorganic filler content.

More specifically, the problem can be solved by
a curable silicone composition comprising: (A) a hot-melt organopolysiloxane resin represented by (R¹₃SiO_{1/2})a(R²₂SiO_{2/2})_{b}(R²SiO_{3/2})_{c}(SiO_{4/2})_{d}(R³O_{1/2)e}
(wherein, each R ¹ is independently a monovalent hydrocarbon group having 1 to 10 carbon atoms, provided at least two of all R¹ in a single molecule are an alkenyl group; each R² is independently a monovalent hydrocarbon group having 1 to 10 carbon atoms that is not an alkenyl group; each R³ is a hydrogen atom or an alkyl group having 1 to 10 carbon atoms; and a, b, c, d and e are numbers satisfying 0.10 ≤ a ≤ 0.40, 0.05 ≤ b ≤ 0.50, 0.30 ≤ c ≤ 0.90, 0 ≤ d ≤ 0.20, 0 ≤ e ≤ 0.05, provided a + b+ c + d = 1);
(B) an organohydrogenpolysiloxane having at least two silicon-bonded hydrogen atoms per molecule; (C) a hydrosilylation catalyst in an amount sufficient to effect a hydrosilylation reaction of the reactive silicone composition; and
(D) 400 to 3,000 parts by mass of a functional organic filler with respect to 100 parts by mass of components (A) to (C), wherein the composition is solid at 25°C and has hot-melt properties at a temperature of 200°C or lower.

The composition may further contain an organosiloxane compound composed of a specific siloxane unit in addition to containing 10 mass% or more of an alkenyl group and may further contain other optional components. Moreover, the composition may be in the form of a particle, a granule, a pellet, or a sheet.

The abovementioned problem is solved by a cured product of this curable silicone composition, its usage as a member in semiconductor devices, and a method for molding the cured product.

### EFFECT OF THE INVENTION

Since the curable silicone composition of the present invention has good hot-melt properties and excellent melting properties, it has the advantages of excellent gap-filling properties during melting, excellent handleability during sealing, and excellent curing properties, making it easy to apply to molding processes. In addition, since the cured product of the composition according to the present invention has high hardness at room temperature and high temperatures in addition to having excellent mechanical strength represented by a low linear expansion coefficient and a high bending strength, the cured product is tough and has excellent bonding strength to substrates, making it suitable as a sealant for semiconductor devices. In particular, a curable silicone composition of the present invention having these properties can be suitably applied to semiconductor devices in which the semiconductor elements are collectively sealed by mold underfill or overmolding.

In addition, such a curable silicone composition can be produced using a simple mixing process and can be efficiently manufactured. In addition, the cured product of the present invention is useful as a member of semiconductor devices and, by using the molding method of the present invention, these cured products can be efficiently produced according to the application.

### DESCRIPTION OF THE PREFERRED EMBODIMENTS

### Curable Silicone Composition

The curable silicone composition of the present invention minimally contains:
(A) a hot-melt organopolysiloxane resin represented by (R¹₃SiO_{1/2})ₐ(R²₂SiO_{2/2})_{b}(R²SiO_{3/2})_{c}(SiO_{4/2})_{d}(R³O_{1/2})ₑ
   (wherein, each R ¹ is independently a monovalent hydrocarbon group having 1 to 10 carbon atoms, provided at least two of all R¹ in a single molecule are an alkenyl group; each R² is independently a monovalent hydrocarbon group having 1 to 10 carbon atoms that is not an alkenyl group; each R³ is a hydrogen atom or an alkyl group having 1 to 10 carbon atoms; and a, b, c, d and e are numbers satisfying 0.10 ≤ a ≤ 0.40, 0.05 ≤ b ≤ 0.50, 0.30 ≤ c ≤ 0.90, 0 ≤ d ≤ 0.20, 0 ≤ e ≤ 0.05, provided a + b+ c + d = 1);
(B) an organohydrogenpolysiloxane having at least two silicon-bonded hydrogen atoms per molecule;
(C) a hydrosilylation catalyst in an amount sufficient to effect a hydrosilylation reaction of the reactive silicone composition; and
(D) 400 to 3,000 parts by mass of a functional organic filler with respect to 100 parts by mass of components (A) to (C),
wherein the composition is solid at 25°C, has hot-melt properties at a temperature of 200°C or lower, and may optionally contain other components. Hereinafter, each component and optional component of the composition will be described. In the present invention, unless otherwise defined, the term "average particle size" means the primary average particle size of the particles.

In the present invention, unless otherwise stated, "having hot-melt properties" means having a softening point of 50°C or higher, having melt viscosity at 180°C (suitably, a melt viscosity of less than 1,000 Pa-s), and having flowing properties. On the other hand, if the softening point is 200 °C or higher, it is defined as "does not have hot-melt properties" because it is above the general operating temperature for molding applications.

### Component (A)

The component (A) is the main component of the present composition and is a hot-melt organopolysiloxane represented by the average unit formula:

(R¹₃SiO_{1/2})ₐ(R²₂SiO_{2/2})_{b}(R²SiO_{3/2})_{c}(SiO_{4/2})_{d}(R³O_{1/2})ₑ

which is a solid at room temperature but softens as the temperature rises. The component (A) is an MDT-type hot-melt organopolysiloxane resin component having at least two alkenyl groups bonded to M units in the molecule, characterized in that the values of a, b, and c, which are the proportions of siloxane units represented by R¹₃ SiO_{1/2} (hereinafter, sometimes referred to as "M units"), siloxane units represented by R²₂ SiO_{2/2} (hereinafter, sometimes referred to as "D units"), and siloxane units represented by R¹₃ SiO_{1/2} (hereinafter, sometimes referred to as "T units"), are within specific ranges.

In the formula, each R¹ is independently a monovalent hydrocarbon group having 1 to 10 carbon atoms, provided at least two of all R¹ in the molecule are alkenyl groups. R¹ is preferably selected from an alkyl group such as a methyl group, an aryl group such as a phenyl group, an aralkyl group such as a benzyl group, and an alkenyl group such as a vinyl group, in which some of the hydrocarbon groups may be optionally substituted with a halogen atom such as fluorine, and preferably selected from an industrial standpoint from a methyl group, a phenyl group, and an alkenyl group described later. Each R² is independently a monovalent hydrocarbon group having 1 to 10 carbon atoms that is not an alkenyl group, with examples thereof including an alkyl group such as a methyl group, an aryl group such as a phenyl group, and an aralkyl group such as a benzyl group, wherein a methyl group or a phenyl group is preferable industrially. Further, it is particularly preferred that at least some R² are an aryl group, more preferably a phenyl group, from the standpoint of imparting suitable hot melt properties to the present component. Each R³ represents a hydrogen atom or an alkyl group having 1 to 10 carbon atoms and is preferably a hydrogen atom, a methyl group, an ethyl group, or a propyl group.

From the standpoint of the curability of the present composition, it is preferred that R¹ in component (A) contain alkenyl groups within the range of 10 to 20 mol% with respect to all silicon-bonded monovalent hydrocarbon groups in the molecule (i.e., the sum of R¹ and R²), and an alkenyl group is included in R¹. When the alkenyl group content in component (A) is within the above range, the strength of the cured product is sufficiently improved and a tough cured product without brittleness is obtained. Exemplary alkenyl groups in component (A) include a vinyl group, an allyl group, a butenyl group, a pentenyl group, and a hexenyl group.

Component (A) is a MDT type hot-melt organopolysiloxane resin component containing M units, D units, and T units in specific ranges, satisfying 0.10 ≤ a ≤ 0.40, preferably 0.10 ≤ a ≤ 0.30, wherein a is a number indicating the proportion of siloxane units represented by the general formula R¹₃ SiO_{1/2} . When the value of a is less than or equal to the aforementioned upper limit, the hardness of the obtained cured product at room temperature is good, while when the value of a is above the lower limit of the lower range, good hot-melt properties can be obtained. In addition, b is a number indicating the proportion of siloxane units represented by the general formula R²₂SiO_{2/2}, satisfying 0.05 ≤ b ≤ 0.50, preferably 0.05 ≤ b ≤ 0.40. This is because when b is below the upper limit of the above range, the hardness of the resulting cured material is sufficiently high, while when b is above the lower limit, the strength of the resulting cured material is improved. In the formula, c is a number indicating the proportion of siloxane units represented by the general formula R²SiO_{3/2}, satisfying 0.30 ≤ c ≤ 0.90, preferably 0.35 ≤ c ≤ 0.85. When the value of c is greater than or equal to the lower limit of the aforementioned range, the hardness of the obtained cured product at room temperature is good. On the other hand, when the value of c is less than or equal to the upper limit of the aforementioned range, the mechanical strength of the obtained cured product is good. Moreover, d is a number indicating the proportion of siloxane units represented by the general formula SiO_{4/2}, satisfying 0 ≤ d ≤ 0.20, preferably 0 ≤ b ≤ 0.10. When the value of d is less than or equal to the upper limit of the aforementioned range, the mechanical strength of the obtained cured product is good. Moreover, e is a number indicating the proportion of units represented by the general formula R²O_{1/2}, satisfying 0 ≤ e ≤ 0.05. When the value of e is less than or equal to the aforementioned upper limit, the hardness of the obtained cured product at room temperature is good. Furthermore, the sum of a, b, c, and d in the formula is 1.

Component (A) exhibits hot-melt properties, is preferably non-fluid at 25°C and has a melt viscosity at 150°C of less than 8,000 Pa-s, preferably less than 5,000 Pa-s, more preferably within the range of 10 to 3,000 Pa-s. Non-fluid refers to not flowing in a no-load state, for example, the state of being lower than the softening point measured by the softening point testing method in the ball and ring method of hot-melt adhesives specified in "Testing methods for the softening point of hot-melt adhesives" of JIS K 6863-1994. That is, in order to be non-fluid at 25°C, the softening point must be higher than 25°C.

Since component (A) is a solid at room temperature as mentioned above, it is preferably used in the form of a particulate resin or liquid mixture obtained by dissolving it in other components necessary for the present composition, from the standpoint of handling when mixed with other components.

When component (A) is in the form of fine particles, while the particle size is not limited, the average primary particle size is preferably within the range of 1 to 5000 µm, within the range of 1 to 500 µm, within the range of 1 to 100 µm, within the range of 1 to 20 µm, or within the range of 1 to 10 µm. The average primary particle size can be obtained, for example, by observation with an optical microscope or an SEM. The shape of particulate component (A) is not limited, with a spherical shape, a spindle shape, a tabular shape, an acicular shape, and an irregular shape being examples; however, a spherical shape or a true spherical shape is preferred because it melts uniformly. In particular, using true spherical fine particles as component (A), the process of producing the present composition by powder mixing or melt-kneading, which will be described later, can be carried out efficiently.

The method for producing component (A) when microparticulated is not limited, with any known method capable of being used. In obtaining microparticulated component (A), some of the components (C) described below, such as, for example, a hydrosilylation reaction catalyst, may be microparticulated together with component (A), which is preferred.

Methods of microparticulating component (A) include, specifically, pulverizing component (A), which is solid at room temperature, using a pulverizer or directly microparticulating the component in the presence of a solvent. While not limited thereto, the pulverizer may be, for example, a roll mill, a ball mill, a jet mill, a turbo mill, or a planetary mill. Methods include directly microparticulating the component (A) in the presence of a solvent, and for example, spraying with a spray dryer or microparticulation with a biaxial kneading machine or belt dryer. When the component (A) is microparticulated, it is preferable to use truly spherical hot-meltable organopolysiloxane resin microparticles obtained by spraying with a spray dryer.

Component (A) having a true spherical shape and an average primary particle size of 1 to 500 µm can be manufactured via the use of a spray dryer or the like. The heating and drying temperature of the spray dryer needs to be appropriately set based on the heat resistance and the like of the organopolysiloxane resin microparticles. In order to prevent secondary aggregation of the organopolysiloxane resin microparticles, the temperature of the organopolysiloxane resin microparticles is preferably controlled below the glass transition temperature thereof. The organopolysiloxane resin microparticles thus obtained can be recovered by a cyclone, a bag filter, or the like.

In order to obtain a uniform component (A), a solvent may be used in the abovementioned step within a range that does not inhibit the curing reaction. Exemplary solvents include, but are not limited to: aliphatic hydrocarbons such as n-hexane, cyclohexane, and n-heptane; aromatic hydrocarbons such as toluene, xylene, and mesitylene; ethers such as tetrahydrofuran and dipropyl ether; silicones such as hexamethyldisiloxane, octamethyltrisiloxane, and decamethyltetrasiloxane; esters such as ethyl acetate, butyl acetate, and propylene glycol monomethyl ether; and ketones such as acetone, methyl ethyl ketone, and methyl isobutyl ketone.

Component (A) may be used after being dissolved in component (B) described later. Since component (B) described below is a silicone compound and is liquid at room temperature, it exhibits a certain degree of mutual solubility with component (A), with component (A) capable of being dissolved by adding 10 to 50 parts by mass of component (B) to 100 parts by mass of component (A). By liquefying component (A), it is possible to efficiently produce the present composition described below by powder mixing or melt-kneading.

### Component (B)

Component (B) is a crosslinking agent of the composition of the present invention and is an organohydrogenpolysiloxane having at least two silicon-bonded hydrogen atoms in the molecule. The structure thereof is not particularly limited and may be linear, branched, cyclic, or resinous. However, from the standpoint of excellent curing characteristics of the resulting composition, it is preferably an organohydrogenpolysiloxane having a hydrogen diorganosiloxy unit represented by HR₂SiO_{1/2} (M^{H} unit, R are each independently a monovalent organic group) at a terminal.

Component (B) is an organopolysiloxane having two or more silicon atom-bound hydrogen atoms in one molecule, with 20 to 70 mol% of all silicon atom-bound organic groups being phenyl groups. The number of silicon atom-bonded hydrogen atoms in the molecule in component (B) is greater than or equal to 2. If this number of silicon atom-bonded hydrogen atoms is present, crosslinking for curing is sufficient, so the hardness of the resulting cured product is good. When the phenyl group content is greater than or equal to the lower limit of the above range, the mechanical strength of the resulting cured product at high temperatures is good. At the same time, when the phenyl group content is less than or equal to the above upper limit, the mechanical strength of the resulting cured product is good.

Examples of the silicon-bonded organic group in component (B) include monovalent hydrocarbon groups having no unsaturated aliphatic bond, as exemplified by an alkyl group such as a methyl group, an ethyl group, a propyl group, a butyl group, a pentyl group, a hexyl group, a heptyl group, a cyclopentyl group, a cyclohexyl group, and a cycloheptyl group; an aryl group such as a phenyl group, a tolyl group, and a xylyl group; and an aralkyl group such as a benzyl group, and a phenethyl group. A phenyl group or an alkyl group having from 1 to 6 carbons is preferred.

There are two types of organopolysiloxane serving as component (B), namely,
(B-1) a linear organopolysiloxane represented by the general formula:

   HR⁴₂SiO(R⁴₂SiO)ₙSiR⁴₂H,

   and
(B-2) a branched organopolysiloxane represented by the average unit formula:

   (R⁴SiO_{3/2})ₚ(R⁴₂SiO_{2/2})_{q}(HR⁴₂SiO_{1/2})ᵣ(SiO_{4/2})ₛ(XO_{1/2})ₜ

These two types of component (B) are preferably used in combination.

In the formula, R⁴ is the same or different phenyl group or an alkyl group with 1 to 6 carbon atoms. Examples of the alkyl group of R⁴ include methyl groups, ethyl groups, propyl groups, butyl groups, pentyl groups, hexyl groups, cyclopentyl groups, and cyclohexyl groups. Among all R⁴, the phenyl group content is within a range of 30 to 70 mol%.

In the formula, n is an integer within a range of 5 to 1,000. In the formula, p is a positive number, q is 0 or a positive number, r is 0 or a positive number, s is 0 or a positive number, and t is 0 or a positive number. Moreover, q/p is a number within a range of 0 to 10, r/p is a number within a range of 0.1 to 5, s/(p + q + r + s) is a number within a range of 0 to 0.3, and t/(p + q + r + s) is a number within a range of 0 to 0.4.

In component (B), it is preferable to use components (B-1) and (B-2) in combination from the standpoint of easily controlling the curing rate of the composition and the crosslinking density of the resulting cured product. A preferable ratio of the two components is within a range of (B-1):(B-2) = 0.05 to 0.6:0.4 to 0.95, preferably 0.05 to 0.5:0.5 to 0.95, and more preferably 0.05 to 0.4:0.5 to 0.95, per alkenyl group in the entire composition.

### Component (C)

Component (C) is a hydrosilylation catalyst used to accelerate curing of the present composition. Platinum-based catalysts, rhodium-based catalysts, and palladium-based catalysts are examples, and platinum-based catalysts are preferred because they can significantly accelerate the curing of the present composition. Exemplary platinum-based catalysts include platinum fine powder, chloroplatinic acid, an alcohol solution of chloroplatinic acid, a platinum-alkenyl siloxane complex, a platinum-olefin complex, a platinum-carbonyl complex, and a catalyst in which these platinum-based catalysts are dispersed or encapsulated with a thermoplastic resin such as silicone resin, polycarbonate resin, acrylic resin, or the like, with a platinum-alkenyl siloxane complex particularly preferable. Exemplary alkenylsiloxanes include: 1,3-divinyl-1,1,3,3-tetramethyldisiloxane; 1,3,5,7-tetramethyl-1,3,5,7-tetravinylcyclotetrasiloxane; alkenyl siloxanes obtained by substituting a portion of the methyl groups of the alkenylsiloxanes with an ethyl group, a phenyl group, or the like; and alkenylsiloxanes obtained by substituting a portion of the vinyl groups of these alkenylsiloxanes with an allyl group, a hexenyl group, or the like. In particular, 1,3-divinyl-1,1,3,3-tetramethyldisiloxane is preferable because the platinum-alkenyl siloxane complex has good stability. Note that as the catalyst for promoting the hydrosilylation reaction, a non-platinum-based metal catalyst such as iron, ruthenium, iron/cobalt, or the like may be used.

Also, from the standpoint of stability of the composition upon production, handleability and improved pot life of the composition, it is preferable that component (B) includes platinum-based catalyst-containing thermoplastic resin microparticles, which can be either microparticles in which the platinum-based catalyst is dissolved or dispersed in the thermoplastic resin, or microcapsule microparticles with a structure in which the platinum-based catalyst is contained as a core within a thermoplastic resin shell. Examples of platinum-based catalysts include platinum black, platinum-supported carbon fine powders, platinum-supported silica fine powders, platinum chlorides, alcohol modified platinum chlorides, platinum olefin complexes, and platinum alkenylsiloxane complexes. The thermoplastic resin is not particularly limited as long as it does not substantially permeate the platinum-based catalyst at least during production and storage of the composition and does not substantially dissolve in the organopolysiloxane which is the main component of the composition; however, the thermoplastic resin preferably has a softening point or glass transition point of 80°C or higher, more preferably 120°C or higher. Specifically, a silicone resin, a polysilane resin, an epoxy resin, an acrylic resin, and a methyl cellulose polycarbonate resin can be suitably used. The softening point is the temperature at which a resin begins to flow under its own weight or by its own surface tension and can be measured by a method of observing pulverized particles under a microscope while increasing the temperature at a constant rate. Furthermore, the glass transition temperature can be measured by DSC (differential scanning calorimeter). In the present invention, either the softening point or glass transition point is preferably 120°C or higher. This is because if the softening point or the glass transition point of the thermoplastic resin is lower than 120°C, there is a concern that the platinum component will start to be eluted in the step of uniformly mixing the present composition, which is described later. Furthermore, while the average particle size of the thermoplastic microparticles containing the platinum-based catalyst is not limited, it is preferably within a range of 0.1 to 500 µm, more preferably within a range of 0.3 to 100 µm. This is because preparing thermoplastic resin microparticles containing a hydrosilylation reaction catalyst with an average particle size below the lower limit of the above range is difficult; however, dispersibility in the curable silicone resin composition is reduced if the average particle size exceeds the upper limit of the above range.

The method of preparing the thermoplastic resin microparticles containing the platinum-based catalyst is not limited, with examples including conventionally known chemical methods such as interfacial polymerization and in-situ polymerization and the like, along with physical and mechanical methods such as coacervation, drying in liquid, and the like. Drying in the liquid method and vapor phase drying method are particularly desirable because obtaining microcapsule microparticles with a narrow particle size distribution will be relatively easy. The microparticles obtained by these methods can be used as they are; however, it is desirable to wash the microparticles with an appropriate cleaning solvent to remove the platinum-based catalyst attached to the surface, in order to obtain a curable silicone composition with excellent storage stability. Herein, an appropriate cleaning solvent is one that does not dissolve the thermoplastic resin, but has a property of dissolving the platinum-based catalyst. Such cleaning solvents include, for example, alcohols such as methyl alcohol and ethyl alcohol, along with low molecular weight organopolysiloxanes such as hexamethyldisiloxane and the like. The ratio of hydrosilylation reaction catalyst to thermoplastic resin is not particularly limited, because the value varies greatly depending on the method of manufacturing granular materials; however, the ratio is preferably such that the amount of platinum-based catalyst to thermoplastic resin is 0.01 mass% or more. This is because if the amount of platinum-based catalyst is less than 0.01 mass%, the physical properties of the cured product of this composition will be impaired unless a large amount of thermoplastic resin microparticles containing the platinum-based catalyst is included in the composition.

The amount of hydrosilylation-reaction catalyst added is preferably an amount in which the metal atoms are within a range of 0.01 to 500 ppm, 0.01 to 100 ppm, or 0.01 to 50 ppm by mass with respect to the overall composition.

### Component (D)

Component (D) of the present invention is an inorganic filler that enables the provision of a curable silicone composition which cures into a cured product with excellent hardness and toughness from room temperature to high temperatures. In the present invention, from the standpoint of realizing mechanical strength (especially a low average linear expansion coefficient, bending strength, etc.) for the resulting cured product, component (C) may be included within the range of 400 to 3,000 parts by mass, preferably 500 to 3,000 parts by mass or 800 to 3,000 parts by mass, per 100 parts by mass of components (A) to (C). Furthermore, from the standpoint of realizing a low average linear expansion coefficient for the cured product, the content of component (D) should be at least 50% by volume of the total composition, preferably at least 60% by volume, more preferably at least 70% by volume, and especially within the range of 80 to 95% by volume.

In order to achieve the aforementioned compounded amount and achieve a low average linear expansion coefficient for the obtained cured product, component (D) is preferably treated with a specific surface treatment agent - in particular, a surface treatment agent at 0.1 to 2.0 mass%, 0.1 to 1.0 mass%, or 0.2 to 0.8 mass% relative to the mass of the entire component (D). Treating component (D) with a surface treatment agent in the treatment amount described above is advantageous in that component (D) can be stably compounded in the composition at a high volume%. In addition, the surface treatment method is optional, with a desired method such as a uniform mixing method using mechanical force (dry), a wet mixing method using a solvent, or the like capable of being used.

Examples of these surface treatment agents include methylhydrogenpolysiloxane, silicone resins, metal soaps, silane coupling agents, and fluorine compounds such as perfluoroalkylsilane and perfluoroalkylphosphate ester salts; however, the silicone-based surface treatment agents described below are particularly preferable. Note that when a silane-based surface treatment agent such as methyltrimethoxysilane or phenyltrimethoxysilane is selected as the surface treatment agent of component (D), the hot-melt properties of the overall composition may be diminished, so component (D) may not be stably compounded to the content indicated by the volume% described above. Moreover, when an alkyltrialkoxysilane having a long-chain alkyl group such as an octyl group is selected as a surface treatment agent, it tends to be possible to maintain the hot-melt properties of the composition and the compounding stability of component (D); however, the strength of the cured product obtained by curing the composition of the present invention may be negatively affected, potentially causing cracking or molding defects.

Here, exemplary organic silicon compounds as surface treatment agents include low molecular weight organic silicon compounds such as silanes, silazanes, siloxanes, and the like, along with organic silicon polymers or oligomers such as polysiloxanes, polycarbosiloxanes, and the like. A so-called silane coupling agent is an example of a preferred silane. Typical examples of the silane coupling agents include alkyltrialkoxysilanes (such as methyltrimethoxysilane, vinyltrimethoxysilane, hexyltrimethoxysilane, octyltrimethoxysilane, decyltrimethoxysilane, and the like) and trialkoxysilanes containing an organic functional group (such as glycidoxypropyltrimethoxysilane, epoxycyclohexyl ethyltrimethoxysilane, methacryloxypropyltrimethoxysilane, aminopropyltrimethoxysilane, and the like). Preferred siloxanes and polysiloxanes include hexamethyldisiloxanes, 1,3-dihexyl-tetramethyldisiloxanes, trialkoxysilyl single-terminated polydimethylsiloxanes, trialkoxysilyl single-terminated dimethylvinyl single-terminated polydimethylsiloxanes, trialkoxysilyl single-terminated organic functional group single-terminated polydimethylsiloxanes, trialkoxysilyl doubly-terminated polydimethylsiloxanes, organic functional group doubly-terminated polydimethylsiloxanes, and the like. When a siloxane is used, the number n of siloxane bonds is preferably within a range of 2 to 150. Examples of preferred silazanes include hexamethyldisilazanes, 1,3-dihexyl-tetramethyldisilazanes, and the like. A polymer having a Si-C-C-Si bond in a polymer main chain is an example of a preferred polycarbosiloxane.

An example of a particularly suitable silicone-based surface treatment agent is a silicone-based surface treatment agent having at least one polysiloxane structure and a hydrolyzable silyl group per molecule. Most suitably, it is preferable to use a silicone-based surface treatment agent having at least one polysiloxane structure and a hydrolyzable silyl group per molecule, with examples thereof including organopolysiloxanes having a straight-chain alkoxysilyl terminal represented by
Structural formula (1):

   R'ₙ(RO)₃₋ₙSiO-(R'₂SiO)ₘ-SiR'ₙ(RO)₃₋ₙ

   or
Structural formula (2):

   R'₃SiO-(R'₂SiO)ₘ-SiR'ₙ(RO)₃₋ₙ.
In the formulas, R is a hydrogen atom or an alkyl group having 1 to 3 carbon atoms (=a methyl group, an ethyl group, or a propyl group), while each R' is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, with the same groups as those described above exemplified. n is a number within the range of 0 to 2, while m is a number within the range of 2 to 200 and may be a number within the range of 2 to 150.

Component (D) is preferably at least one inorganic filler that does not have a softening point between room temperature and 200°C and may be a component that improves the handleability of the composition in addition to imparting mechanical strength and other properties to the cured product of the composition. As the inorganic filler in component (D), a reinforcing filler, a white pigment, a thermally conductive filler, a conductive filler, a phosphor, and a mixture of at least two of these are exemplified, and in particular, it preferably contains a reinforcing filler having an average particle size of 10.0 µm or more in order to achieve a filling amount with a high volume%. Examples of organic fillers that can be used as component (D) include a silicone resin filler, a fluorine resin filler, and a polybutadiene resin filler. Note that the shape of these fillers is not particularly limited and may be spherical, spindle-shaped, flat, needle-shaped, amorphous, or the like.

Component (D) is preferably an inorganic filler having an average particle size of 10.0 µm or more, and in particular, since the hardness at room temperature to high temperatures and the rate of change in a storage modulus are small, it is particularly preferable that the component be a spherical inorganic filler having an average particle size of 10.0 µm or more. Such an inorganic filler can be blended or filled in relatively large amounts with respect to components (A) to (C), in addition to there being a practical advantage in that the mechanical strength of the cured product can be further improved. At the same time, it is possible and preferable to blend an inorganic filler or an organic filler having an average particle size of 5 µm or less for the purpose of imparting or improving the light reflection properties, electrical conductivity, thermal conductivity, fluorescent properties, stress relaxation properties, etc. of the composition of the present invention.

When the present composition is used for applications such as sealants, protective agents, adhesives, light reflecting materials, etc., since it imparts mechanical strength to the cured product in addition to improving the protective properties or adhesiveness, it is preferable to incorporate a reinforcing filler as component (E). Exemplary reinforcing filler include fumed silica, precipitated silica, fused silica, calcined silica, fumed titanium dioxide, quartz, calcium carbonate, diatomaceous earth, aluminum oxide, aluminum hydroxide, zinc oxide, zinc carbonate, glass beads, glass powder, talc, clay, and mica, kaolin, silicon carbide, silicon nitride, aluminum nitride, carbon black, graphite, titanium dioxide, calcium sulfate, barium carbonate, magnesium carbonate, magnesium sulfate, barium sulfate, cellulose, aramid, and the like. These reinforcing fillers may also be surface treated with organoalkoxysilanes such as: methyltrimethoxysilane; organohalosilanes such as trimethylchlorosilane; organosilazanes such as hexamethyldisilazane; siloxane oligomers such as α,ω-silanol group- blocked dimethylsiloxane oligomers, α,ω-silanol group-blocked methylphenylsiloxane oligomers, α,ω-silanol group-blocked methylvinylsiloxane oligomers, and the like. Further, as reinforcing fillers, fibrous inorganic fillers such as calcium metasilicate, potassium titanate, magnesium sulfate, sepiolite, zonolite, aluminum borate, rock wool, glass fiber, carbon fiber, asbestos fiber, metal fiber, wollastonite, attapulgite, sepiolite, aluminum borate whisker, potassium titanate fiber, calcium carbonate whisker, titanium oxide whisker and ceramic fiber; and fibrous fillers such as aramid fiber, polyimide fiber and polyparaphenylene benzobisoxazole fiber may be used. In addition, tabular fillers or granular fillers such as talc, kaolin clay, calcium carbonate, zinc oxide, calcium silicate hydrate, mica, glass flake, glass powder, magnesium carbonate, silica, titanium oxide, alumina, aluminum hydroxide, magnesium hydroxide, barium sulfate, calcium sulfate, calcium sulfite, zinc borate, barium metaborate, aluminum borate, calcium borate, sodium borate, aluminum nitride, boron nitride, silicon nitride, and pulverized products of the above fibrous fillers may be used.

In particular, from the standpoint of imparting hardness to the cured material at room to high temperatures, it is preferred that more than 50 mass% of all component (D) be spherical silica or aluminum oxide (alumina) with an average particle size of 10.0 µm or larger.

Component (D) may contain silicone microparticles and the stress relaxation characteristics, etc. can adjusted as desired. While silicone microparticles include non-reactive silicone resin microparticles and silicone elastomer microparticles, silicone elastomer microparticles are suitably exemplified from the standpoint of improving flexibility or stress relaxation properties.

The silicone elastomer microparticles are a crosslinked product of linear diorganopolysiloxane primarily including diorganosiloxy units (D-units). The silicone elastomer microparticles can be prepared by a crosslinking reaction of diorganopolysiloxane by a hydrosilylation reaction, a condensation reaction of a silanol group, or the like, and in particular, the silicone elastomer microparticles can be suitably obtained by a crosslinking reaction of organohydrogenpolysiloxane having a silicon bonded hydrogen atom on a side chain or a terminal with diorganopolysiloxane having an unsaturated hydrocarbon group such as an alkenyl group on a side chain or a terminal under a hydrosilylation reaction catalyst. The silicone elastomer microparticles may have various shapes such as spherical, flat, and irregular shapes, but are preferably spherical in terms of dispersibility, with true spherical being more preferable among these. Commercial products of such silicone elastomer microparticles include, for example, "Torefil-E series" and "EP Powder series" manufactured by Dow Corning Toray Company, Ltd., and "KMP series" manufactured by Shin-Etsu Chemical Co., Ltd. The silicone elastomer microparticles may be subjected to a surface treatment.

As the elastomer fine particles, acrylonitrile-butadiene rubber, isoprene, styrene-butadiene rubber, ethylene-propylene rubber or the like may be used.

When the present composition is used as a wavelength conversion material for an LED, a phosphor may be blended as component (D) in order to convert the emission wavelength from the optical semiconductor element. There are no particular limitations to this phosphor, with examples thereof including yellow, red, green, and blue light phosphors, which include oxide phosphors, oxynitride phosphors, nitride phosphors, sulfide phosphors, oxysulfide phosphors, and the like, that are widely used in light emitting diodes (LED). Exemplary oxide phosphors include: yttrium, aluminum, and garnet-type YAG green to yellow light phosphors containing cerium ions; terbium, aluminum, and garnet-type TAG yellow light phosphors containing cerium ions; and silicate green to yellow light phosphors containing cerium or europium ions. In addition, exemplary oxynitride phosphors include silicon, aluminum, oxygen, and nitrogen type SiAlON red to green light phosphors containing europium ions. Exemplary nitride phosphors include calcium, strontium, aluminum, silicon, and nitrogen type CASN red light phosphors containing europium ions. Exemplary sulfide phosphors include ZnS green light phosphors containing copper ions or aluminum ions. Exemplary oxysulfide phosphors include Y₂O₂S red light phosphors containing europium ions. In the composition, two or more of these phosphors may be used in combination.

In addition, the composition may contain a thermally conductive filler or a conductive filler to impart thermal or electrical conductivity to the cured product. Exemplary thermally conductive fillers or conductive filler include: metal fine powders such as gold, silver, nickel, copper, aluminum; fine powders obtained by depositing or plating a metal such as gold, silver, nickel, copper or the like on the surface of a fine powder such as ceramic, glass, quartz, organic resin or the like; metal compounds such as aluminum oxide, magnesium oxide, aluminum nitride, boron nitride, zinc oxide, or the like; graphite; and a mixture of two or more of these. When electrical insulation is required for the present composition, a metal oxide-based powder or a metal nitride-based powder is preferable, and in particular, an aluminum oxide powder, a zinc oxide powder, or an aluminum nitride powder is preferable.

In addition, the composition may contain a coloring agent to give the cured product a color. Examples of such colorants include black titanium dioxide, pitch (residues from distillation of tar obtained by dry distillation of organic substances such as oil, coal, and wood), carbon black, acetylene black, and red iron oxide. Acetylene black is suitable for reducing the content of metallic impurities. Black dyes, such as anthraquinone dyes (sometimes described as "anthraquinone"), azine dyes, azo dyes, disazo dyes, and chromium complex dyes, may be included, and when used in combination with yellow dyes such as methine dyes, disazo dyes, azocobalt complex dyes, and azochrome complex dyes, the color can approach that of a black pigment.

In addition, the composition may optionally contain a thermally expansive filler. By blending the thermally expansive filler, the volume expansion coefficient of the composition according to the present invention can be improved, with the dispersion unevenness of the composition capable of being reduced in some cases. Preferably, the thermally expandable filler has a core-shell structure and includes a volatile expansion agent inside a shell in the core-shell structure. The volatile expansion agent refers to a substance that generates gas at a temperature below the softening point of the shell. Since the thermal expansive filler has a structure in which the volatile expansion agent is encapsulated as a core agent inside a gas barrier shell, heat can cause the above volatile expansion agent to become gaseous and the shell to soften and expand. Such ingredients are exemplified in, for example, JP 2020-084094 A, and are available as FN-100SSD and FN-80GSD from Matsumoto Yushi Seiyaku Co., Ltd.

When the cured product made by curing this composition is used for magnetic components such as a magnetic needle, coil, electromagnetic shielding material, etc., it may contain magnetic particles as component (C). These magnetic particles include one or more than one elements selected from the group consisting of Fe, Cr, Co, Ni, Ag, and Mn, and may include magnetic particles made of iron (Fe), an Fe-Si alloy, an Fe-Al alloy, an Fe-Ni alloy, an Fe-Co alloy, an Fe-Si-Al alloy, an Fe-Si-Cr alloy, an Fe-Cr alloy, carbonyl iron, stainless steel, or the like as soft magnetic particles and also may be magnetic particles made up carbonyl iron from the standpoint of availability. These magnetic particles may be surface-treated with a silane compound, a titanate compound, an aluminate compound, or a partial hydrolyzate thereof as in the case of the inorganic filler described above, preventing deactivation of a curing catalyst or a crosslinking agent and improving storage stability in some cases. In addition, these magnetic particles may have a surface coating layer containing a siloxane polymer, for example, using the method described in JP 2021-036013 A.

### Component (E)

The composition of the present invention may further contain, as component (E), an organosiloxane compound containing more than 10 mass% of alkenyl groups in the molecule, represented by the formula

(R¹₃SiO_{1/2})_{a'}(R²₂SiO_{2/2})_{b'}(R²SiO_{3/2})_{c'}(SiO_{4/2})_{d'}(R³O_{1/2})_{e'}

(wherein, each R¹ is independently a monovalent hydrocarbon group having 1 to 10 carbon atoms, provided at least 2 of all R¹ in a molecule are alkenyl groups, while each R² is independently a monovalent hydrocarbon group having 1 to 10 carbon atoms not containing an alkenyl group; and each R³ is a hydrogen atom or an alkyl group having 1 to 10 carbon atoms alkyl group having 1 to 10 carbon atoms).

Component (E) is an organosiloxane compound that contains a certain amount of alkenyl groups in the molecule and functions as a regulator of crosslink density. Specifically, by using the above components (A) to (C) in combination, the crosslinking density of the cured product of the present composition can be increased to improve the mechanical strength thereof and the melt viscosity of the resulting hot-melt curable silicone composition can be reduced to improve the handling, workability, and gap filling properties.

In the formula, each of R¹, R², R³ are the same groups mentioned above, with examples including the same groups mentioned above. A', b', c', d' and e'are numbers which satisfy the following 0.40 ≤ a' ≤ 0.80, 0 ≤ b' ≤ 0.90, 0 ≤ c' ≤ 0.60, 0 ≤ d' ≤ 0.50, and 0 ≤ e' ≤ 0.05, where a' + b' + c' + d' = 1.

From the standpoint of improving the mechanical strength of the cured product obtained by curing this composition, at least two of the R¹ in the (E) component should be alkenyl groups and the molecule should contain at least 10 mass%, preferably 10 to 40 mass%, of alkenyl groups in R¹. When the alkenyl group content of component (E) is within the above range, the strength of the cured product is sufficiently improved and a tough cured product without brittleness is obtained. Exemplary alkenyl groups in component (E) may include a vinyl group, an allyl group, a butenyl group, a pentenyl group, and a hexenyl group.

In the formula, a' is a number indicating the proportion of siloxane units represented by the general formula R¹₃SiO_{1/2}, satisfying 0.40 ≤ a' ≤ 0.90, and preferably 0.50 ≤ a' ≤ 0.85. This is because when a' is below the upper limit of the above range, the strength of the resulting cured material is good, while when a' is above the lower limit of the range, the effect of reducing the melt viscosity of the composition is sufficient. In the formula, b' is a number indicating the proportion of siloxane units represented by the general formula: R²₂SiO_{2/2}, satisfying 0 ≤ b' ≤ 0.50. This is because when b' is below the upper limit of the above range, the effect of improving the strength of the resulting cured material is sufficient. In addition, c' is a number indicating the proportion of siloxane units represented by the general formula R²SiO_{3/2}, and satisfying 0 ≤ c' ≤ 0.60. This is because the mechanical strength of the cured product is better when c' is below the upper limit of the above range. Moreover, d' is a number indicating the proportion of siloxane units represented by the general formula SiO_{4/2}, and satisfying 0 ≤ d≤ 0.50. This is because the mechanical strength of the resulting cured product is good when d' is below the upper limit of the above range. In addition, e' is a number indicating the proportion of units represented by the general formula: R²O_{1/2} and satisfying 0 ≤ e' ≤ 0.05. This is because the hardness of the resulting cured material at room temperature is better when e' is below the upper limit of the above range. Note that the sum of a', b', c', and d' in the formula is 1.

Because of the structure described above, component (E) is liquid at room temperature, making it particularly suitable if its viscosity at 25°C is 10,000 mPa-s or less.

The composition may also contain (F) a cure retarder, (G) an adhesive agent, and (H) an organic wax as optional ingredients, as long as the object of the invention is not compromised.

### Component (F)

Component (F) is a curing retarder, which may effectively suppress side reactions, especially when this composition is cured by hydrosilylation reaction, and may further improve the storage stability of the composition according to the present invention and its usable time when heated and melted.

The available cure retardants are not limited in structure and type and can be selected from known hydrosilylation reaction inhibitors. Examples include 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl-2-propynyloxy)silane, vinyl tris(1,1-dimethyl propynyloxy)silane, and other alkynyloxysilanes.

It is particularly preferable to use a compound with a boiling point of 200°C or higher under atmospheric pressure as component (F). The composition according to the present invention can be produced through a process involving heating, such as melting and mixing of the compositions, from the standpoint of compositional uniformity. However, the use of a compound with a low boiling point as a retardant curing agent may cause some or all of the retardant to volatilize during the melting and mixing process, potentially resulting in a loss of the targeted retardant effect on the final curable silicone composition. Methyl-tris (1, 1-dimethyl-2-propynyloxy) silane has a boiling point of 245 °C under atmospheric pressure and is one example of a suitable component (F).

While any amount of component (F) can be used, it is preferably within the range of 1 to 10,000 ppm by mass with respect to the overall composition.

### Component (G)

Component (G) is an adhesion imparting agent, and includes an organic silicon compound having at least one alkoxy group bonded to a silicon atom in the molecule. Examples of this alkoxy group include a methoxy group, an ethoxy group, a propoxy group, a butoxy group, and a methoxyethoxy group, with a methoxy group particularly preferable. Moreover, examples of groups other than alkoxy groups, bonded to the silicon atom of the organic silicon compound, include: halogen substituted or unsubstituted monovalent hydrocarbon groups such as an alkyl group, an alkenyl group, an aryl group, an aralkyl group, and a halogenated alkyl group; glycidoxyalkyl groups such as a 3-glycidoxypropyl group and a 4-glycidoxybutyl group; epoxycyclohexylalkyl groups such as a 2-(3,4-epoxycyclohexyl)ethyl group and a 3-(3,4-epoxycyclohexyl)propyl group; epoxyalkyl groups such as a 3,4-epoxybutyl group and 7,8-epoxyoctyl groups; acryl group-containing monovalent organic groups such as 3-methacryloxypropyl groups; and hydrogen atoms. This organic silicon compound preferably has a group that may react with an alkenyl group or a silicon-bonded hydrogen atom in this composition, and specifically, preferably has a silicon-bonded hydrogen atom or an alkenyl group. Moreover, because favorable adhesion can be imparted to various base materials, this organic silicon compound preferably has at least one epoxy group-containing monovalent organic group per molecule. Examples of such an organic silicon compound include an organosilane compound, an organosiloxane oligomer, and an alkyl silicate. Exemplary molecular structures of this organosiloxane oligomer or alkyl silicate include a linear structure, a partially branched linear structure, a branched structure, a cyclic structure, and a network structure, among which a linear structure, a branched structure, and a network structure are particularly preferable. Exemplary organic silicon compounds include: silane compounds such as 3-glycidoxypropyltrimethoxysilane, 2- (3,4-epoxycyclohexyl) ethyltrimethoxysilane, and 3-methacryloxypropyltrimethoxysilane; siloxane compounds with at least one of each of a silicon-bonded alkenyl group or a silicon-bonded hydrogen atom and a silicon-bonded alkoxy group in one molecule; a silane compound or siloxane compound having at least one silicon-bonded alkoxy group; a mixture of siloxane compounds having at least one each of silicon-bonded alkenyl group and silicon-bonded alkenyl group in one molecule, a reaction mixture of an amino group-containing organoalkoxysilane and an epoxy group-containing organoalkoxysilane, and an organic compound having at least two alkoxysilyl groups containing bonds other than silicon-oxygen bonds between their silyl groups in one molecule; general formula: R^{a} ₙSi(OR^{b}) ₄₋ₙ
(wherein, R^{a} represents an organic group containing a monovalent epoxy group, while R^{b} represents an alkyl group having from 1 to 6 carbon atoms, or a hydrogen atom. n represents a number within a range of 1 to 3),
reaction mixtures of a vinyl group-containing siloxane oligomer (including a chain or ring shaped structure), and an epoxy group-containing trialkoxysilane, methyl polysilicate, ethyl polysilicate, and epoxy group-containing ethyl polysilicate. The adhesion imparting agent is preferably in the form of a low viscosity liquid, with the viscosity thereof not limited, but preferably within the range of 1 to 500 mPa-s at 25°C. In addition, while not limited thereto, the content of this adhesion imparting agent is preferably within the range of 0.01 to 10 mass parts with regard to 100 mass parts of the overall present composition.

In the present invention, a reaction mixture of an organoalkoxysilane containing an amino group and an organoalkoxysilane containing an epoxy group are examples of a particularly suitable adhesive imparting agent. These components improve the initial adhesion of the curable silicone composition to the various substrates with which it is in contact during the curing process, especially low-temperature adhesion even to unwashed adherends. Such a reaction mixture is disclosed in JP 52-8854 B and JP 10-195085 A.

Exemplary alkoxysilanes having an amino group-containing organic group forming such component include an aminomethyltriethoxysilane, 3-aminopropyltrimethoxysilane, 3-aminopropyltriethoxysilane, 3-aminopropylmethyldimethoxysilane, N-(2-aminoethyl)aminomethyltributoxysilane, N-(2-aminoethyl)-3-aminopropyltrimethoxysilane, N-(2-aminoethyl)-3-aminopropylmethyldimethoxysilane, and 3-anilinopropyltriethoxysilane.

Moreover, exemplary epoxy groups containing organoalkoxysilanes may include 3-glycidoxyprolyltrimethoxysilane, 3-glycidoxypropylmethyldimethoxysilane, 2-(3,4-epoxy cyclohexyl)ethyltrimethoxysilane, and 2-(3,4-epoxy cyclohexyl)ethylmethyldimethoxysilane.

The ratio of the alkoxysilane having an amino group containing organic group to the alkoxysilane having an epoxy group containing organic group is, in terms of molar ratio, preferably within the range of (1:1.5) to (1:5), and particularly preferably within the range of (1:2) to (1:4). This component can be easily synthesized by mixing an alkoxysilane having an amino group-containing organic group and alkoxysilane having an epoxy group-containing organic group as described above to cause a reaction at room temperature or by heating.

In particular, in the curable hot melt silicone composition of the present invention, when an alkoxysilane having an amino group-containing organic group is reacted with an alkoxysilane having an epoxy group-containing organic group by the method described in JP 10-195085 A, a carbasilatrane derivative cyclized by an alcohol exchange reaction and represented by the following general formula is especially preferred. 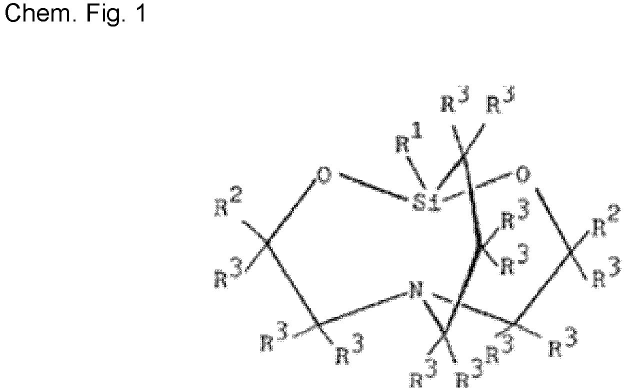 {wherein, R¹ is an alkyl group, an alkenyl group, or an alkoxy group, while R² is the same or different group selected from the group consisting of groups represented by the general formula: 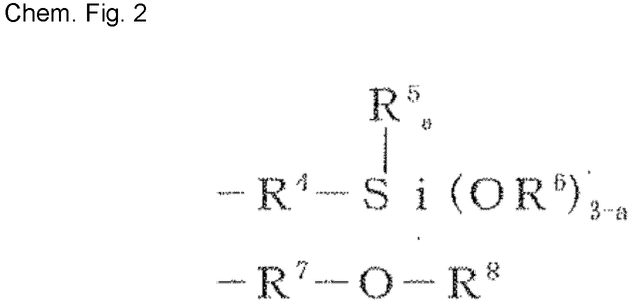 (wherein, R⁴ is an alkylene group or alkyleneoxyalkylene group, R⁵ is a monovalent hydrocarbon group, R⁶ is an alkyl group, R⁷ is an alkylene group, R⁸ is an alkyl group, alkenyl group, or acyl group, and a is 0, 1, or 2 .)
R³ is the same or different hydrogen atom or alkyl group .}

Exemplary carbasilatrane derivatives may include carbasilatrane derivatives having a silicon-bonded alkoxy group or a silicon atom-bonded alkenyl group per one molecule represented by the following structure. 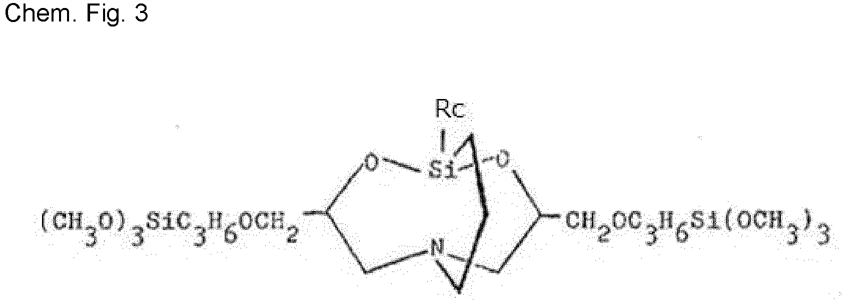 (wherein, Rc is a group selected from a methoxy group, ethoxy group, vinyl group, allyl group, and hexenyl group.)

In the present invention, a silatrane derivative represented by the following structural formula may also be used as an adhesion-imparting agent.

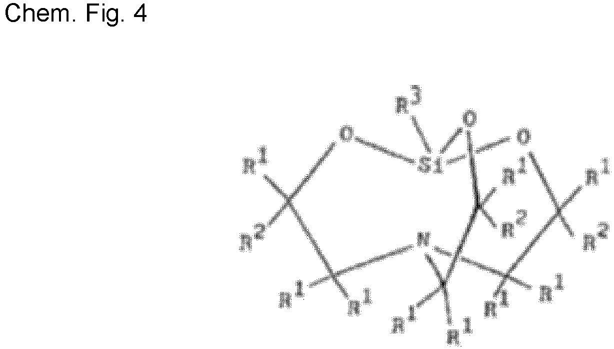

In the formula, R¹ is the same or different hydrogen atom or alkyl group, with R¹ particularly preferably being a hydrogen atom or a methyl group. Moreover, R² in the above formula is the same or different group selected from the group consisting of a hydrogen atom, an alkyl group, and an alkoxysilyl group-containing organic group represented by general formula: -R⁴-Si(OR⁵)ₓS⁶₍₃₋ₓ₎, provided that at least one R² is an alkoxysilyl group-containing organic group. Exemplary alkyl groups R² include methyl groups. Moreover, in the alkoxysilyl group-containing organic group of R², R⁴ in the formula is a divalent organic group, with examples thereof including an alkylene group or an alkylene oxyalkylene group, wherein an ethylene group, a propylene group, a butylene group, a methylene oxypropylene group, or a methylene oxypentylene group is preferable. Moreover, R⁵ in the formula is an alkyl group having 1 to 10 carbon atoms, preferably a methyl group or an ethyl group. Moreover, R⁶ in the formula is a substituted or unsubstituted monovalent hydrocarbon group, preferably a methyl group. Moreover, in the formula, x is 1, 2, or 3, preferably 3.

Exemplary such alkoxysilyl group-containing organic groups of R² include the following groups.

-(CH₂)₂Si(OCH₃)₂(CH₂)₂Si(OCH₃)₂CH₃

-(CH₂)₃Si(OC₂H₅)₂(CH₂)₃Si(OC₂H₅)(CH₃)₂

-CH₂O(CH₂)₃Si(OC₃)₃

-CH₂O(CH₂)₃Si(OC₂H₅)₃

-CH₂O(CH₂)₃Si(OCH₃)₂CH₃

-CH₂O(CH₂)₃Si(OC₂H₅)₂CH₃

-CH₂OCH₂Si(OCH₃)₂CH₂OCH₂Si(OCH₃)(CH₃)₂

R³ in the above formula is at least one group selected from the group consisting of a substituted or unsubstituted monovalent hydrocarbon group, an alkoxy group having 1 to 10 carbon atoms, a glycidoxyalkyl group, an oxiranylalkyl group, and an acyloxyalkyl group, with exemplary monovalent hydrocarbon groups of R³ including alkyl groups such as methyl groups, exemplary alkoxy groups of R³ including methoxy groups, ethoxy groups, and propoxy group, exemplary glycidoxypropyl groups of R³ including 3-glycidoxypropyl groups, exemplary oxiranylalkyl groups of R³ including 4-oxiranylbutyl groups and 8-oxiraniloctyl groups, and exemplary acyloxyalkyl groups of R³ including acetoxypropyl groups and 3-methacryloxypropyl groups. In particular, R³ is preferably an alkyl group, an alkenyl group, or an alkoxy group, further preferably an alkyl group or an alkenyl group, with particularly suitable examples thereof including a group selected from a methyl group, vinyl group, allyl group, and hexenyl group.

While the amount of component (G) used is not particularly limited, from the standpoint of improving adhesion to difficult-to-bond substrates, it is suitably within the range of 0.1 to 1.0 mass% of the total composition, with 0.2 to 1.0 mass% being more preferred. The amount of component (G) may range from 5 to 50 parts by mass to 100 parts by mass of the total of components (A) and (B), and may range from 5 to 40 parts by mass.

### Component (H)

Component (H) is a hot-melt fine particle other than component (A) and is specifically an organic wax having a melting point within the range of 30 to 160 °C. One or more types selected from hot-melt synthetic resins, waxes, fatty acid metal salts, etc. are examples of component (H). The wax component exhibits low kinematic viscosity at high temperatures (150 °C) and forms a melt with excellent flowability. In addition, by combining components (A) to (C) described above, the wax component in the melt making up the present composition spreads quickly throughout the composition at high temperatures, thereby lowering the viscosity of the substrate surface to which the molten composition is applied and of the composition as a whole, rapidly lowering the surface friction of the substrate and the molten composition, and significantly increasing the fluidity of the composition as a whole. Therefore, the viscosity and flowability of the molten composition can be greatly improved by adding only a very small amount to the total amount of other components.

The wax component may be petroleum waxes such as paraffin, natural waxes such as carnauba wax, or synthetic waxes such as montanate ester wax, as long as they meet the above conditions of drop point and kinematic viscosity when melted. From the standpoint of the technical effect of the present invention, a hot melt component consisting of fatty acid esters of fatty acid metal salts or erythritol derivatives is preferred, with metal salts of higher fatty acids such as stearic acid, palmitic acid, oleic acid, and isononanoic acid, as well as pentaerythritol tetrastearate, dipentaerythritol adipate stearate, glycerol tri-18-hydroxystearate, and pentaerythritol fulstearate particularly preferred. Here, the types of fatty acid metal salts described above are also not particularly limited, with suitable examples including: alkali metal salts such as lithium, sodium, potassium, and the like; alkaline earth metal salts such as magnesium, calcium, barium, and the like; or zinc salts.

Particularly suitable as the wax component are fatty acid metal salts and erythritol derivatives having a free fatty acid content of 5.0% or less, particularly preferably 4.0% or less, and 0.05 to 3.5%. Examples of such a component include at least one or more stearic acid metal salts. The use of a hot-melt component having a melting point of 150 °C or less, selected from the following is most preferred, specifically, calcium stearate (melting point 150 °C), zinc stearate (melting point 120 °C), and magnesium stearate (melting point 130 °C) pentaerythritol tetrastearate (melting point 60-70 °C), pentaerythritol adipate stearate (melting point 55-61 °C), pentaerythritol full stearate (melting point 62-67 °C) and the like.

Regarding the amount of the wax component used, taking the overall composition as 100 mass parts, the content of the component is within the range of 0.01 to 5.0 mass parts and may be 0.01 to 3.5 mass parts or 0.01 to 3.0 mass parts. If the amount of the wax component used exceeds the upper limit, the adhesiveness and mechanical strength of the cured product obtained from the cured silicone composition of the present invention may be insufficient. If the amount used is less than the lower limit, sufficient fluidity while heating and melting may not be achieved.

In addition, the composition may contain the following as optional ingredients as long as they do not detract from the object of the invention: heat-resistant agents such as iron oxide (red iron oxide), cerium oxide, cerium dimethylsilanolate, cerium salts of fatty acids, cerium hydroxide, and zirconium compounds; dyes, non-white pigments, flame retardants, aluminum hydroxide, magnesium hydroxide, zinc borate, zinc molybdate, phosphazene and other slow-heating agents, hydrotalcite, bismuth oxides, yttrium oxides and other ion scavengers and pH adjusters, hindered phenol compounds, hindered amine compounds, thioether compounds and other antioxidants, soft magnetic particles such as pure iron, silicon steel, iron-cobalt alloy, iron-nickel alloy, iron-chromium alloy, iron-aluminum alloy, carbonyl iron, stainless steel, or composite materials containing one or more of these, inorganic flame retardants (such as hydrated metal compounds such as aluminum hydroxide), halogen-based flame retardants, phosphorus-based flame retardants, organometallic salt-based flame retardants, silicone oil, silicone rubber, polyisoprene, 1,2-polybutadiene, 1,4-polybutadiene and other polybutadienes, styrene-butadiene rubber, acrylonitrile-butadiene rubber, carboxyl-terminated butadiene acrylonitrile rubber, polychloroprene, poly(oxypropylene), poly(oxytetramethylene) glycol, polyolefin glycol, poly-ε-caprolactone and other thermoplastic elastomers, polysulfide rubber, fluoroelastomers and other low stress modifiers, barium titanate (BaTiOs), strontium titanate (SrTiOs), lead zirconate titanate (Pb(Zr,Ti)O₃, also known as PZT), alumina (Al₂O₃, also known as aluminum oxide), zirconia (ZrO₂, also known as zirconium dioxide), magnesia (MgO, also known as magnesium oxide), silica (SiO₂, also known as silicon dioxide), titania (TiO₂, also known as titanium dioxide), aluminum nitride (AlN), silicon nitride (Si₃N₄), silicon carbide (SiC), calcium barium zirconate titanate (BCTZ), dielectric ceramics such as polyvinylidene fluoride, metal salt stabilizers such as copper chloride, copper I iodide, copper acetate, cerium stearate, etc.; antioxidants and heat stabilizers such as hindered amine-based, hindered phenol-based, sulfur-containing compound-based, acrylate-based, and phosphorus-based organic compounds; UV absorbers such as benzophenones, salicylates, benzotriazoles, weathering agents, and light stabilizers, etc.

### Use of the Present Composition

The present composition can take the form of particles, granules, pellets, or sheets depending on the manufacturing process. Here, the granular or granular composition can be used in the form of a pellet-shaped molded product or a tablet-shaped molded product by further tableting the composition by a known method.

Here, "pellet" and "tablet" are general names or common names of granular tablet-molded products made of a resin composition. While the shape of the pellet is not limited, it is usually spherical, elliptical spherical, or cylindrical. While the size of the pellets is not limited, it may, for example, have an average particle size or circular equivalent diameter of 500 µm or greater and an average particle size or circular equivalent diameter of 1 mm or greater.

### Method for manufacturing the curable silicone composition

This composition can be produced as a granular composition by powder mixing components (A) through (D), as well as any other optional components, at a temperature of 100°C or less. The powder mixer used in the present manufacturing method is not limited, with examples including a uniaxial or biaxial continuous mixer, a two-roll mixer, a ROSS mixer, a Hobart mixer, a dental mixer, a planetary mixer, a kneader mixer, a laboratory mill, a small grinder, and a Henschel mixer, preferably a laboratory mill, a small grinder, or a Henschel mixer. These mixers can be used to create powder curable silicone compositions, with curable tablet compositions for transfer molding capable of being produced by pressing the aforementioned granular compositions together in a tableting machine or the like.

In particular, when this composition is to be used in compression molding, it is preferable to go beyond mere mechanical mixing and melt-knead it in a uniaxial or biaxial continuous mixer, twin roll, Ross mixer, kneader mixer, etc. at a temperature of 150°C or less to form a compositionally uniform granular or sheet-like form for use.

This is because compression molding requires less material transfer and, unlike transfer molding, requires a completely homogenized composition. For example, a sheet made of a curable silicone composition having an average thickness of 100 to 1,000 µm is advantageous in that it has hot-melt properties and heating-curability at high temperatures, and so in particular, demonstrates excellent handleability and melting characteristics when used in compression molding or the like. Granules made of curable silicone compositions with a particle size of 0.1 to 10 mm have hot-melt properties and are heat curable under high temperatures, making them particularly suitable for compression molding to seal or bond large areas. Such sheet or granular compositions can be produced by melting and kneading the curable granular composition obtained by the above method in a continuous kneader, or by feeding the components of this composition separately into a continuous kneader for constant melting and kneading, then forming them into sheets or granules via the method described below.

### Method of manufacturing a curable silicone sheet

The curable silicone sheet is characterized in that it contains components (A) to (D) as essential components and other components as optional components, with the manufacturing method including the following steps 1 to 3.
Step 1: Kneading the components of the curable silicone composition while heating and melting
Step 2: Laminating the heat-melted mixture obtained in step 1 between films with at least one release surface.
Step 3: Stretching the laminate obtained in step 2 between rolls to form a curable silicone sheet with a specific film thickness
Here, "having hot-melt properties" refers to a property in which the softening point is within a range of 50°C to 200°C and involves softening or flowing upon heating.

### Step 1

Step 1 above is the step of kneading the components of the curable silicone composition of the present invention while heating and melting them. By heating and kneading the heat-melting mixture at a temperature above its softening point, suitably within the temperature range of 50°C to 150°C, more suitably 50°C to 120°C, the entire composition is melted or softened and components (A) to (D) and the optional components can be uniformly dispersed throughout.

The mixing equipment in step 1 is not limited and can be batch-type mixing equipment such as a kneader, Banbury mixer, Henschel mixer, planetary mixer, 2-roll mill, 3-roll mill, Ross mixer, or Labo Plastomill, or continuous-type mixing equipment such as a single screw extruder or twin screw extruder with heating and cooling functions, but is selected according to the processing time efficiency and ability to control shear heating. In terms of the processing time, the mixing apparatus may be a continuous heating and kneading apparatus such as a single screw extruder or a twin screw extruder, or may be a batch mixer such as a Labo Plastomill. However, from the standpoint of the production efficiency of the curable silicone sheet, a continuous heating and kneading apparatus such as a single screw extruder or a twin screw extruder is preferably used.

When the mixture is pressed and formed into a sheet in step 3 after passing through step 2, a uniform thin-layer sheet can be formed in a single pressurization, which has the practical benefit of avoiding molding defects and cracks in the sheet. In contrast, if the temperature is less than the abovementioned lower limit, softening will be insufficient, likely making it difficult to obtain a molten or softened mixture (even upon using mechanical force) in which each component is uniformly dispersed throughout. Even if such a mixture is pressure molded into a sheet shape in step 4 via step 3, a uniform thin-layer molded sheet cannot be formed, potentially causing breakage or cracking of the sheet. On the other hand, if the temperature exceeds the abovementioned upper limit, the curing agent reacts during mixing, potentially causing the entire amount thereof to undergo significant thickening or curing, thereby losing its hot-melt properties and forming a cured product. For this reason, it is preferable to use a particulate platinum-containing hydrosilylation reaction catalyst dispersed or encapsulated in a thermoplastic resin with a softening point above the kneading temperature of component (C).

Regarding the method of feeding the components of the present invention into the aforementioned kneading device, each component may be fed separately to the kneading device at a constant rate or all components may be mixed in powder form as a granular curable silicone composition and then fed into the kneading device.

### Step 2

Step 2 is a step involving laminating the mixture obtained after heating and melting in step 1 between two films, each having at least one release surface, and is a preliminary step for pressure molding in step 3. By forming the laminate in which the mixture obtained in step 1 is sandwiched between films, press molding by rolling stretching can be performed from above the film to obtain a sheet-like molded article, with only the film capable of being removed from the sheet-like molded article using a release surface after molding.

According to the use form of the resulting curable silicone sheet, both of the two films preferably have a release surface, and in step 2, the mixture obtained in step 1 is particularly preferably laminated between the release surfaces of the respective films. Taking this type of layered form, it is possible to obtain a laminated sheet which can be peeled from both sides, wherein a thin-layer curable silicone sheet is sandwiched between releasable films via pressure molding in step 3 and optional subsequent cutting, and wherein, while in use, the film on both sides can be peeled off to expose only the curable silicone sheet without concern for damaging the formed curable silicone sheet.

While the substrate of the film used in step 2 is not particularly limited, examples thereof include paperboard, cardboard paper, clay-coated paper, polyolefin laminate paper (polyethylene laminate paper, in particular), synthetic resin films/sheets, natural fiber cloth, synthetic fiber cloth, artificial leather cloth, and metal foil. Synthetic resin films and sheets are particularly preferable, with exemplary synthetic resins including polyimide, polyethylene, polypropylene, polystyrene, polyvinyl chloride, polyvinylidene chloride, polycarbonate, polyethylene terephthalate, and nylon. When heat resistance is required, a heat-resistant synthetic resin film such as a polyimide, polyetheretherketone, polyethylene naphthalate (PEN), liquid crystal polyacrylate, polyamide-imide, polyether sulfone, and the like is particularly preferable. At the same time, for applications such as a display device in which visibility is required, a transparent substrate and specifically a transparent material such as a polypropylene, polystyrene, polyvinylidene chloride, polycarbonate, polyethylene terephthalate, PEN, and the like is preferable.

The thickness of the film is not particularly limited, but is normally approximately 5 to 300 µm.

The film is preferably provided with at least one release layer, with the release layer preferably in contact with the mixture obtained in step 1. As a result, the hot-melt curable silicone sheet that is pressed and molded can easily be peeled from the film via steps 2 and 3. The release layer may also be referred to as a release liner, a separator, a release layer, or a release coating layer and may preferably be a release layer having a release coating ability such as a silicone-based release agent, a fluorine-based release agent, an alkyd-based release agent, a fluorosilicone-based release agent, or the like, or may be formed as a substrate itself which is not prone to adhering to the hot-melt curable silicone sheet of the present invention by forming physically fine irregularities in the surface of the substrate. The release layer may also be referred to as a release liner, a separator, a release layer, or a release coating layer and may preferably be a release layer having a release coating ability such as a silicone-based release agent, a fluorine-based release agent, an alkyd-based release agent, a fluorosilicone-based release agent, or the like, or may be formed as a substrate itself which is not prone to adhering to the hot-melt curable silicone sheet of the present invention by forming physically fine irregularities in the surface of the substrate.

In step 2, the mixture obtained in step 1 is laminated between two films. This step is not particularly limited; however, the mixture obtained in step 1 is supplied when discharged or applied onto a release layer of one film, while a laminate is formed by pasting together a release layer of the other film from above the mixture. At this time, in the manufacturing step of the continuous curable silicone sheet, each film is transported to the feed position of the mixture of step 1 via a rotary roll, at which time, a lamination operation is performed between the films.

The feed amount of the mixture obtained in step 1 between the films in step 2 can be designed according to the manufacturing speed and scale. As an example, a feed rate of 1 to 10 kg/hr of the mixture obtained in step 2 can be provided between the films; however, needless to say, the present invention is not limited thereto. However, in step 2, the amount of the mixture obtained in step 1 that is laminated between the films must be determined based on the average thickness of the curable silicone sheet designed in step 3 and must be a thickness that allows rolling processing in step 3.

If the hot-melt viscosity of the mixture obtained in step 1 is low and the fluidity is high, in step 2, the mixture obtained after heating and melting in step 1 is preferably discharged while molded into a film shape using a die and laminated between the films. Here, the die is used to temporarily mold the mixture, so the type and the thickness during temporary molding are not particularly limited; however, the die can be temporarily molded to form a substantial sheet shape having a thickness within a range of 100 to 2000 µm (=2 mm) using a T-die, which is preferable.

If the hot-melt viscosity of the mixture obtained in step 1 is low and the fluidity is high, it is preferable to include the step involving cooling the entire laminate obtained in step 2 or adjusting the temperature thereof as a step prior to step 3 or in step 3. This is because, when the heated melt is cooled into a solid state, the pressure molding in step 3 is effectively performed. The cooling step is not particularly limited, but can be performed by cooling the mixture (supplied or laminated on the film) within a range of -50°C to room temperature utilizing cooling rolls, etc. via a cooling means (such as air cooling or a cooling solvent). The details on temperature adjustment are described in step 3.

In contrast, if the hot-melt viscosity of the mixture obtained in step 1 is high and fluidity is poor, the semi-solid mixture may be fed and laminated onto the film without temporary molding in step 2.

### Step 3

Step 3 is a step in which the laminate obtained in the abovementioned step 2 is stretched between rolls to mold a curable silicone sheet having a specific film thickness, wherein the mixture obtained in step 1 is pressurized and stretched from above the film and molded into the form of a uniform curable silicone sheet.

The rolling process in step 3 can be performed using a known rolling method such as roll rolling on the laminate obtained in step 2. In particular, roller rolling is advantageous in that the curable silicone sheet can be designed to have a desired thickness by adjusting the gap between the rollers. For example, a curable silicone sheet having excellent flatness and very few defects on the sheet surface as well as inside the sheet can be obtained by adjusting the gap between the rollers to a constant level such that the average thickness is within a range of 10 to 2,000 µm, then rolling. More specifically, for roller rolling, the gap between the rollers is particularly preferably adjusted to be within a range of 1.5 to 4.0-fold the average thickness of the target organopolysiloxane cured product film.

By stretching in accordance with step 3, an essentially flat, 10 to 2000 µm thick, curable silicone sheet can be obtained. By roller stretching the heated and melted mixture of step 1 in the form of a laminate between the release films in accordance with step 2, a peelable laminate containing a curable silicone sheet having hot-melt properties, which has low defects and excellent handleability, can be obtained.

### Temperature adjustment in step 3

In step 3, when the laminate obtained in step 2 is stretched between rolls, the rolls preferably further include a temperature adjustment function, and when roll rolling, the temperature of the entire laminate is preferably adjusted, and if necessary, heated or cooled. Adjusting the temperature is beneficial in that the gap between the rollers can be stably maintained and the flatness and uniformity (uniformity of film thickness) of the obtained curable silicone sheet having hot-melt properties can be improved. The specific temperature adjustment range can be appropriately designed depending on the heat resistance of the film, the thickness of the curable silicone sheet (design thickness), the reactivity thereof, etc., but is generally within a range of 5 to 150°C.

### Cutting step

Step 3 enables obtaining a peelable laminate in which the curable silicone sheet is interposed between the peelable films and may optionally include a step of cutting the laminate containing the curable silicone sheet. Moreover, the curable silicone sheet may have a step involving winding via a winding apparatus. Thereby, a peelable laminate containing a hot-melt curable silicone sheet of a desired size can be obtained.

### Laminate

The laminate obtained by the above process is a laminate consisting of components (A) to (D) along with optional components in the present invention, is substantially flat, and is a curable silicone sheet with hot-melt properties, a thickness of 10 to 2000 µm, and a laminated structure between films with at least one release surface. Note that the film may be provided together with a release surface, which is preferable.

### Curable silicone sheet

The curable silicone sheet obtained by the manufacturing method has hot-melt properties and exhibits adhesive and bonding properties when heated and melted, so it has excellent moldability, gap-filling properties, and adhesive strength, and can be used as a die attach film, film adhesive, and film sealant. It is also suitable for use as a curable silicone sheet for compression molding, press molding, and vacuum lamination.

Specifically, the curable silicone sheet obtained via the manufacturing method of the present invention may be peeled from the releasable film, the disposed at a desired site such as a semiconductor. Subsequently, a film adhesive layer that utilizes gap filling properties with respect to irregularities or gaps may be formed on an adherend, then temporarily fixed, disposed, and applied together between the adherends. Further, the curable silicone sheet may be heated to at least 150°C and adhered between the adherends by the cured product of the curable silicone sheet. Note that the releasable film may be released after heating the curable silicone sheet and forming a cured product, wherein the release timing may be selected according to the application and use method of the curable silicone sheet.

Because the curable silicone sheet has hot-melt properties, it is possible to soften or fluidize the sheet by heating the sheet prior to final curing, and for example, thereby forming the adhesive surface by filling the unevenness or gap without any gaps even if there are irregularities on the attached surface of the adherend. Exemplary heating means of the curable silicone sheet include various thermostatic baths, hot plates, electromagnetic heating apparatuses, heating rolls, etc. In order to perform application and heating more efficiently, for example, an electric heat press, a diaphragm type laminator, a roll laminator, etc. are preferably used.

### Manufacturing Method of the Granular Curable Silicone Composition

The present composition is in the form of granules in which the entire composition including at least the above-described components (A) to (C) is compositionally homogenized beyond the degree of mixing by simple mechanical force. Such granular compositions are preferably obtained by melting and kneading the entire composition via heating, and more specifically, components (A) to (C) and any other optional components are melt-kneaded within a temperature range of 50 to 150°C, more preferably 50 to 120°C, in a uniaxial or biaxial continuous mixer, twin roll, Ross mixer, kneader mixer, etc., then molded into granular form for use. A specific production method is illustrated below.

The method for manufacturing a granular curable silicone compositions of the present invention
Comprises step 1 to step 3 below, but is not particularly limited as long as the curable silicone composition comprises components (A) to (C) above and any other optional components, component (C) content is within the range of 400 to 3,000 mass parts per 100 mass parts of the total of components components (A) and (B), the components are melted and mixed at a temperature range of 50 to 150°C, more suitably 50 to 120°C, and the composition is molded by melt kneading into granules with an average particle size within the range of 0.1 to 10.0 mm.
Step 1: A step of kneading the components of the curable silicone composition while heating and melting within the temperature range of 50°C to 150°C, more preferably 50°C to 120°C.
Step 2: A step of cooling the mixture after heating and melting obtained in step 1 while discharging
Step 3: A step of cutting or breaking up the mixture obtained in step 2 to form a granular curable silicone composition

### Step 1

Step 1 is the step of kneading the components of the curable silicone composition of the present invention while heating and melting them within the temperature range of 50°C to 150°C. By heating and kneading the heat-melting mixture at a temperature above its softening point, preferably within the temperature range of 50°C to 120°C, the entire composition is melted or softened and components (A) to (C) and the optional components can be uniformly dispersed throughout.

The mixing equipment in step 1 is not limited and can be batch-type mixing equipment such as a kneader, Banbury mixer, Henschel mixer, planetary mixer, 2-roll mill, 3-roll mill, Ross mixer, or Labo-plastomill, or continuous-type mixing equipment such as a single screw extruder or twin screw extruder with heating and cooling functions, but is selected according to efficiency of processing time and ability to control shear heating. In terms of the processing time, the mixing apparatus may be a continuous heating and kneading apparatus such as a single screw extruder or a twin screw extruder, or may be a batch mixer such as a labo Plastomill. However, from the standpoint of the production efficiency of the granular curable silicone composition, a continuous heating and kneading apparatus such as a single screw extruder or a twin screw extruder is preferably used.

The mixture is made into granules in step 3 after passing through step 2. If the temperature is below the lower limit mentioned above, softening may be insufficient so it may be difficult to obtain a melted or softened mixture in which each component is uniformly dispersed throughout even with mechanical force and such a mixture may not have excellent uniformity of each component, so when the resulting granular curable silicone composition is used in the molding process, a uniform cured product may not be obtained. On the other hand, if the temperature exceeds the abovementioned upper limit, the curing agent reacts during mixing, potentially causing the entire amount thereof to undergo significant thickening or curing, thereby losing its hot-melt properties and forming a cured product. For this reason, it is preferable to use as component (C) a particulate hydrosilylation reaction catalyst dispersed or encapsulated in a thermoplastic resin whose softening point is above the kneading temperature.

Regarding the method of feeding the components of the present invention into the aforementioned kneading device, each component may be fed separately to the kneading device at a constant rate or all components may be powder-mixed by mechanical force or other means into a granular curable silicone composition before being fed into the kneading device.

### Step 2

Step 2 is the process of discharging the mixture melted and kneaded in step 1 from the kneading device. The mixture can be discharged in any shape; however, since the mixture is cut and broken up in step 3 to form granules, it is preferable to use a shape that is easy to cut and break up. Examples include a rod shape (strand shape) with a diameter of approximately 0.5 to 5.0 mm or a sheet shape with a thickness of approximately 0.5 to 5.0 mm. Since the mixture should be a non-sticky solid for granulation in step 3, the temperature of the dispensed mixture should be lowered to near room temperature by natural or rapid cooling. Examples of rapid cooling methods include the use of coolers and water cooling.

### Step 3

Step 3 is a step in which the mixture discharged in step 2 is cut or broken up into granules. If the mixture is sufficiently hard to be broken up by shear stress alone at room temperature, it can be broken up and granulated by passing it through two rolls or the like. Here, the size and shape of the granules obtained in step 3 can be adjusted to some extent by controlling the dimensions of the mixture discharged in step 2 and the gap between the rolls. In the present invention, the average particle size of the granular molding should be within the range of 0.1 to 10.0 mm. If the mixture cannot be broken up by rolls, etc., it can be discharged as a rod-shaped mixture in step 2 and cut to a predetermined size by a rotary cutter, etc. while cooling to obtain granules.

The granular curable silicone compositions obtained by this manufacturing method are highly homogenized compositionally, making them less less likely to be non-homogeneous and incur physical migration of the composition during molding, such as compression molding, press molding, and lamination. This makes it easy to form the entire composition uniformly and has the advantage of being applicable even in for molding processes in which shear pressure is not generated. Since the above advantages are not lost by secondary molding of the granular composition, the granular curable silicone composition may be used as tablets or pellets for transfer molding by compressing or tableting with a tableting machine, etc.

### Cured Product

The above curable silicone composition has hot-melt properties, and in addition to having excellent flow properties when melted (hot-melted), handleability and curability, it also has high hardness at room to high temperatures after curing, a low linear expansion coefficient, and excellent mechanical strength as typified by strong bending strength. As a result, it is tough and has excellent bonding strength to base materials, forming a cured material suitable for semiconductor components, etc. Due to the molding method described below, it is preferable that this composition be cured by heat curing within the range of 80°C to 200°C. In the present invention, physical properties such as linear expansion coefficient, bending strength, and hardness of the cured product can be easily designed on the basis of the types of component (A) and component (E) used, along with the quantitative range of component (D).

### Linear expansion coefficient of the cured product

The cured product made by curing the above composition has an average linear expansion coefficient of 30 ppm/°C or less, preferably 20 ppm/°C or less, and more preferably 15 ppm/°C or less. within a range of 25°C to 200°C. Within this range, because the difference in the average linear expansion coefficient between the cured product and the substrate used is low, the residual stress in the obtained integral molded article can be reduced, improving the reliability of the device.

### Bending strength of the cured product

Furthermore, since it is suitable as a sealant for semiconductors which is required to have high hardness and high strength, the bending strength of the cured product measured by the method specified in JIS K 6911-1995 "Testing Methods for Thermosetting Plastics" is preferably 15 MPa or more, or 20 MPa or more.

### Hardness of the cured product

Since it is suitable as a protective member for a semiconductor or the like, the cured product obtained by curing the present composition preferably has a type-D durometer hardness of 20 or more at 25°C. This type-D durometer hardness is determined by a type-D durometer in accordance with the JIS K 6253-1997 "Hardness Testing Methods for Vulcanized Rubber and Thermoplastic Rubber."

### Method of molding cured product

The composition can be cured by a method including at least the following steps (I) to (III).
(I) a step involving heating to a temperature of 100°C or higher to melt the present composition;
(II) a step involving injecting the curable silicone composition obtained in step (I) into a mold or a step involving distributing the curable silicone composition obtained in step (I) to a mold by clamping; and
(III) a step involving curing the curable silicone composition injected in the step (II).

The composition can be suitably used in a molding method including a coating process in which overmolding and underfilling of a semiconductor device are simultaneously performed (so-called mold underfilling method). Furthermore, due to the above characteristics, the composition can be suitably used in molding methods including a coating process (including so-called wafer molding) in which the surface of a semiconductor substrate (including a wafer substrate) with one or more semiconductor elements mounted is covered and the gaps between the semiconductor elements are overmolded to be filled with the cured material.

Transfer molding machines, compression molding machines, injection molding machines, auxiliary ram molding machines, sliding molding machines, double ram molding machines, molding machines for low-pressure inclusion, vacuum lamination, etc. can be used in the steps above. In particular, the composition of the present invention can be suitably used for the purpose of obtaining a cured product by transfer molding and compression molding.

Finally, in step (III), the curable silicone composition injected (applied) in step (II) is cured. When an organic peroxide is used as component (C), the heating temperature is preferably 150°C or higher or 170°C or higher.

Since it is suitable as a protective member for a semiconductor or the like, the cured product obtained by curing the present composition preferably has a type-D durometer hardness of 20 or more at 25°C. This type-D durometer hardness is determined using a type-D durometer in accordance with the JIS K 6253-1997 "Hardness Testing Methods for Vulcanized Rubber and Thermoplastic Rubber."

### Use of composition

The present composition has hot-melt properties, flowability while melted (hot-melt), and superior handleability and curability, making it preferable as a sealant or underfill agent for semiconductors, a sealant or underfill agent for power semiconductors such as SiC, GaN, and the like, a sealant or light reflecting material for optical semiconductors such as light emitting diodes, photodiodes, phototransistors, laser diodes, and the like, or an electrical and electronic adhesive, potting agent, protecting agent, and coating agent. Since the composition has hot-melt properties, it is also suitable as a material for transfer molding, compression molding, or injection molding. In particular, it is suitable for use as a sealant for semiconductors that use the mold underfill method or the wafer molding method during molding. Furthermore, a sheet of this composition can be used as a curable film adhesive or as a buffer layer for stress between two substrates with different coefficients of linear expansion.

As mentioned above, the composition is suitable as a sealant for semiconductors, etc., and by replacing some or all of a conventionally known sealant in the process of sealing semiconductors, etc. using a molding method such as the overmolding method used with conventionally known sealants (including non-silicone hot-melt sealants such as epoxy sealants), the underfill method, the mold underfill method in which these are performed all at once, and the wafer molding method, semiconductor packages, power semiconductor modules, small integrated devices such as MEMS and micro sensors (fingerprint sensors), magnetic components such as coils containing magnetic particles, flexible substrates (stretchable wiring boards) for wearable devices, and semiconductor/optical components such as optical waveguides connected to electrical circuit boards and connectors can be manufactured. For example, the curable silicone compositions of the present invention can be used to replace some or all of the sealants (including, in particular, silicone elastomer sealants, pastes containing functional fillers and hot-melt sealants) described in JP 2021-097123 A, JP 2021-024945 A, JP 2020-132771 A, JP 2020-132750 A, JP 2020-125399 A, JP 2020-123670 A, JP 2020-084094 A, JP 2020-088055 A, JP 2019-006905 A, JP 2018-188494 A, JP 2017-179185 A, JP 2020-023643 A, JP 2020-063459 A, JP 2020-090634 A, JP 2020-088055 A, JP 2020-107767 A, JP 2021-080411 A, JP 2021-036013 A, JP 2020-152844 A, JP 2020-158684 A, JP 2021-019031 A, JP 2021-059741 A, JP 2020-057775 A, JP 2021-015985 A, JP 2015-114390 A, and JP 2016-177106. If necessary, the technical elements applicable to these sealant compositions may be applied to the present invention; wherein, the compositions according to the present invention may be adjusted with respect to their composition, properties of the cured product, and melting characteristics, which is also preferable.

### Application of the cured product

Although the applications of the cured product of the present invention are not particularly limited, the composition of the present invention has hot-melt properties and superior moldability, in addition to the cured product having excellent adhesive properties, high elasticity modulus, and low linear expansion coefficient. Therefore, the cured product obtained by curing the present composition can be suitably used as a member for semiconductor devices, and can be suitably used as a sealant for a semiconductor element, an IC chip or the like, or as a light reflecting material of an optical semiconductor device.

Although semiconductor devices equipped with members made of the cured material of the present invention are not particularly restricted, it is especially preferred that the semiconductor devices be mounted on power semiconductor devices, optical semiconductor devices, and flexible semiconductor devices that can expand, contract, or deform.

### Examples

The hot-melt curable silicone composition of the present invention and manufacturing method thereof are described in detail by means of examples and comparative examples. Note that, in the formulas, Me, Ph, and Vi represent a methyl group, a phenyl group, and a vinyl group, respectively. Moreover, the softening points and melt viscosities of the curable silicone compositions of each example and comparative example were determined by the following methods. Moreover, the curable silicone composition was heated at 180°C for 2 hours to produce a cured product, with the adhesion to various substrates determined via the following methods. The results are shown in Table 1.

### Softening point of curable silicone composition

The curable silicone composition was molded into cylindrical pellets of ϕ14 mm × 22 mm. The pellets were placed on a hot plate set at 25°C to 100°C and kept pressed from above for 10 seconds with a load of 100 grams, and after the load was removed, the amount of deformation of the pellet was measured. The temperature at which the deformation amount in the height direction was 1 mm or more was defined as the softening point.

### Melt viscosity

The melt viscosity of curable silicone compositions at 180°C was measured using a Koka flow tester CFT-500EX (Shimadzu Corporation) under 100 kgf of pressure and a nozzle having a diameter of 1.0 mm diameter.

### Curing Properties

The curable silicone composition was vulcanized for 600 seconds at the molding temperature (160°C) using a curastometer (PREMIERMDR manufactured by Alpha Technologies) in accordance with the method specified in JIS K 6300-2:2001, "Unvulcanized Rubber - Physical Properties - Part 2: Determination of Vulcanization Characteristics Using a Vibratory Vulcanization Tester" to measure the curing properties. Note that for measurement, a lump of the curable hot-melt silicone composition was weighed out at approximately 5 g, sandwiched between 50 µm-thick PET films, then placed on a lower die, with measurement started once the upper die had closed. The measurements were made using an R-type die for rubber, with an amplitude angle of 0.53°, a vibration frequency of 100 times/minute, and a maximum torque range of 230 kgf-cm. As a result of the measurement, the time (ts-1) required to exceed a torque value of 1 dNm was read in units of seconds.

### Storage Stability

The curable silicone composition was aged in an oven at 40°C for one week. The curing properties were then measured using the method described above, and the ts-1 value was read.

### Bending strength of cured product

The curable silicone composition was heated at 180°C for 2 hours to prepare a cured product. The bending strength of the cured product was determined by the method prescribed in JIS K 6911-1995 "General Testing Method for Thermosetting Plastics."

### Die shear strength

A curable silicone composition was placed at four locations, approximately 500 mg each, on various substrates of 25 mm × 75 mm. Next, the composition was covered with a 10 mm square glass chip having a thickness of 1 mm, then heated and cured for two hours under thermocompression bonding using a 1 kg plate at a temperature of 180°C. Thereafter, the mixture was cooled to room temperature and the die shear strength determined using a shear strength determination apparatus (bond tester SS-100KP, available from Seishin Trading Co., Ltd.)

### Linear expansion coefficient curve of cured product

The curable silicone composition of Example 1 was cured via the method described above to prepare a cured product. The linear expansion coefficient of the cured product was determined by TM9200 manufactured by Advance Riko, Inc. within a temperature range of 20°C to 200°C.

Organopolysiloxane resins containing a hydrosilylation reaction catalyst were prepared by the method shown in Reference Example 1 below, while the organopolysiloxane resin particles were prepared by the method shown in Reference Examples 2 and 3. The presence or absence of hot melt properties was evaluated by the presence or absence of a softening point. In the reference examples, the 1,1,3,3-tetramethyl-1,3-divinyl disiloxane used for the platinum complex that is the hydrosilylation reaction catalyst is described as "1,3- divinyltetramethyldisiloxane".

### Reference Examples 1 to 6

Toluene solutions of resinous organopolysiloxanes (1) through (6) were prepared by dissolving 550 g of each resinous organopolysiloxane (in white solid form at 25°C) represented by the average unit formula in Table 1 below in 450 g toluene in a 1 L flask. Table 1 also shows the softening points of these resinous organopolysiloxanes.

**Table 1**

| Reference Example No. | Average unit formula of resinous organopolysiloxane | Softening Point [°C] |
|---|---|---|
| 1 | (ViMe₂SiO_{1/2})_{0.23}(Me₂SiO_{2/2})_{0.11}(Ph₂SiO_{2/2})_{0.04}(MeSiO_{3/2})_{0.08}(PhSiO_{3/2})_{0.54} | 70 |
| 2 | (ViMe₂SiO_{1/2})_{0.23}(Ph₂SiO_{2/2})_{0.07}(PhMeSiO_{2/2})_{0.04}(MeSiO_{3/2})_{0.35}(PhSiO_{3/2})_{0.31} | 65 |
| 3 | (ViMe₂SiO_{1/2})_{0.23}(Me₂SiO_{2/2})_{0.11}(MeSiO_{3/2})_{0.31}(PhSiO_{3/2})_{0.35} | 60 |
| 4 | (Me₂ViSiO_{1/2})_{0.20}(PhSiO_{3/2})_{0.80} | 100 |
| 5 | (Me₃SiO_{1/2})_{0.14}(ViMe₂SiO_{1/2})_{0.11}(MeSiO_{3/2})_{0.53}(PhSiO_{3/2})_{0.22} | 53 |
| 6 | (ViMeSiO_{2/2})_{0.15}(Me₂SiO_{2/2})_{0.10}(PhSiO_{3/2})_{0.75} | 100 |

### Reference Example 7

A toluene solution of a resinous organopolysiloxane containing 10 ppm of platinum metal in mass units was prepared by injecting 270.5 g of a 55 mass% toluene solution of a resinous organopolysiloxane represented by the average unit formula:

(Me₂ViSiO_{1/2})_{0.20}(PhSiO_{3/2})_{0.80}

which is a white solid at 25°C, 21.3 g of a diphenylsiloxane capped at both molecular terminals with dimethylhydrogensiloxy groups and having a viscosity of 5 mPa-s (silicon-atom bonded hydrogen atom content=0.6 mass%) represented by the formula:

HMe₂SiO(Ph₂SiO)SiMe₂H,

(in an amount such that the amount of silicon atom-bonded hydrogen atoms in this component is 0.5 mol relative to 1 mol of vinyl groups in the resinous organopolysiloxane), along with 0.034 g of a 1,3-divinyltetramethyldisiloxane solution of platinum 1,3-divinyltetramethyldisiloxane complex (platinum metal content=approximately 4000 ppm) 0.034 g (in an amount such that the amount of platinum metal is 10 ppm in mass units with respect to this liquid mixture) into a 1 L flask and stirring uniformly at room temperature. The temperature in the flask was then raised to 100°C in an oil bath and stirred for 2 hours under toluene reflux to prepare a toluene solution of organosiloxane crosslinked with vinyl groups (1), which is composed of resinous organosiloxane derived from the above resinous organopolysiloxane and chain-like organosiloxane derived from the above diphenylsiloxane and not involved in the above reaction. Note that when the organosiloxane crosslinked product (2) was analyzed by FT-IR, peaks of silicon atom-bonded hydrogen atom were not observed. The softening point of the organosiloxane crosslinked product (1) was 75°C.

### Reference Example 8

A toluene solution of a resinous organopolysiloxane (7) containing 10 ppm of platinum metal in mass units was prepared by injecting 270.5 g of a 55 mass% toluene solution of a resinous organopolysiloxane represented by the average unit formula:

(ViMe₂SiO_{1/2})_{0.23}(Ph₂SO_{2/2})_{0.07}(PhMeSiO_{2/2})_{0.04}(MeSiO_{3/2})_{0.35}(PhSiO_{3/2})_{0.31}

and 0.034 g of a 1,3-divinyltetramethyldisiloxane solution of a 1,3-divinyltetramethyldisiloxane complex of platinum (platinum metal content = approx. 4000 ppm), and stirring the components uniformly at room temperature (25°C) in a 1L flask. The softening point of this resinous organopolysiloxane (7) was 100°C.

### Reference Examples 9-16: Preparation of hot-melt silicone particles (1) to (8)

Toluene solutions of resinous organopolysiloxanes (1) to (7) prepared in Reference Examples 1 to 6 and 8, along with the toluene solution of organosiloxane crosslinker (1) prepared in Reference Example 7, each listed in Table 2, were microparticulated by spray drying at 40°C while removing toluene in order to prepare true spherical hot-melt silicone particulates (1) to (8). Table 2 shows the average particle size and other information obtained from observing each particle under an optical microscope.

**Table 2**

| Reference Example No. | HM properties Silicone fine particulate No. | Silicone component in raw toluene solution | Particle size range (µm) | Average particle size (µm) |
|---|---|---|---|---|
| 9 | (1) | Resinous organopolysiloxane (1) | 5-10 | 7.5 |
| 10 | (2) | Resinous organopolysiloxane (2) | 5-10 | 7.2 |
| 11 | (3) | Resinous organopolysiloxane (3) | 5-10 | 7.7 |
| 12 | (4) | Resinous organopolysiloxane (4) | 5-10 | 7.9 |
| 13 | (5) | Resinous organopolysiloxane (5) | 5-10 | 7.4 |
| 14 | (6) | Resinous organopolysiloxane (6) | 5-10 | 7.7 |
| 15 | (7) | Organosiloxane crosslinked material (1) | 5-10 | 7.5 |
| | | * Has resin linear structure | | |
| | | ** Contains 10 ppm of hydrosilylation reaction catalyst | | |
| 16 | (8) | Resinous organopolysiloxane (7) | 5-10 | 7.7 |
| | | ** Contains 10 ppm of hydrosilylation reaction catalyst | | |

### Reference Example 17: Preparation of resinous organopolysiloxane solution (1)

Transparent resinous organopolysiloxane solution 1 was prepared by adding, to 55.8g of (A2) hot-meltable silicone particles (2),
2.9 g of a diphenylsiloxane with dimethylhydrogensiloxy groups sealed at both ends of the molecular chain (content of hydrogen atoms bonded to silicon atoms = 0.6 mass%) with a viscosity of 5 mPa-s, represented by (C1) Formula: HMe₂SiO(Ph₂SiO)SiMe₂H; and
22.3 g of branched-chain organopolysiloxane with a viscosity of 25 mPa-s having two or more silicon atom-bonded hydrogen atoms in one molecule (content of silicon atom-bonded hydrogen atoms = 0.65 mass%), represented by average unit formula (C2):

   (PhSiO_{3/2})_{0.4}(HMe₂SiO_{1/2})_{0.6},

   then
   stirring the contents at 60°C for 30 minutes.

### Examples 1 to 14 and Comparative Examples 1 to 7

In the examples and comparative examples, the following components were used.
(D) Organic Fillers
(D1) Fused silica with an average particle size of 14.5 µm (S6105P manufactured by Nippon Steel Materials Micron, Inc.)
(D2) Fused silica with an average particle size of 0.7 µm (SPH507M manufactured by Nippon Steel Materials Micron)
(D3) Fused silica with an average particle size of 17.0 µm (Nippon Steel Materials Micron's S6050P)
(D4) Carbon black with an average particle size of 35 nm (DENKA Black Pressed by DENKA Corporation)
(ds) Treatment agent for inorganic filler
(ds-1) Dimethylpolysiloxane represented by Me₂ViSiO(Me₂SiO)₂₉Si(OMe)₃ (viscosity 23 mPas)
(ds-1) Dimethylpolysiloxane represented by Me₃SiO(Me₂SiO)₁₁₀Si(OMe)₃
(H) Wax
(H) Calcium stearate (Kawamura Kasei)
(A) Hot-melt silicone components
(A1) to (A8): Hot-meltable silicone particles (1) to (8) prepared in Reference Examples 9-16
(A9) Resinous organopolysiloxane solution 1 of Reference Example 17 (mixture of component (A2), component (C1), and component (C2))
(E) Organosiloxane compounds
(E1) Branched organopolysiloxane containing vinyl groups at the molecular ends with a viscosity of 5 mPa-s (vinyl group content = 23 mass%), represented by the following formula:

   (ViMe₂SiO_{1/2})_{0.75}(PhSiO_{3/2})_{0.25}
(E2) Linear organopolysiloxane containing vinyl groups at the molecular ends with a viscosity of 8 mPa-s (vinyl group content = 16 mass%), represented by the following formula:

   (ViMe₂SiO)₂Sikh₂
(E3) Branched organopolysiloxane containing vinyl groups at the molecular ends with a viscosity of 300 mPa-s (vinyl group content = 19 mass%), represented by the following formula:

   (Me₂ViSiO_{1/2})_{0.55}(Me₃SiO_{1/2})_{0.05}(SiO_{4/2})_{0.40}
(E'1) Linear organopolysiloxane containing vinyl groups at the molecular ends with a viscosity of 900 mPa-s (vinyl group content = 1.5 mass%), represented by the following formula:

   ViMe₂SiO(MePhSiO)_{17.5}SiViMe₂
(E'2) Linear organopolysiloxane containing vinyl groups at the molecular ends with a viscosity of 15,000 mPa-s (vinyl group content = 0.6 mass%), represented by the following formula:

   ViMe₂SiO(MePhSiO)₉₂SiViMe₂
(B) Si siloxane
(B1) Triphenylphosphine with dimethylhydrogensiloxy groups sealed at both ends of the molecular chain with a viscosity of 5 mPa-s (content of hydrogen atoms bonded to silicon atoms = 0.6 mass%), represented by the following formula:

   HMe₂SiO(Ph₂SiO)SiMe₂H
(B2) Branched-chain organopolysiloxane with a viscosity of 25 mPa-s having two or more silicon atom-bonded hydrogen atoms per molecule (content of silicon atom-bonded hydrogen atoms = 0.65 mass%) represented by the average unit formula:

   (PhSiO_{3/2})_{0.4}(HMe₂SiO_{1/2})_{0.6}.
(C) a hydrosilylation reaction catalyst
(C1) Thermoplastic polycarbonate resin containing 4000 ppm of 1,3-vinyl-1,1,3,3-tetramethyldisiloxane complex of Pt (0 value) as platinum content (softening point of thermoplastic resin = 150°C)
(F) Inhibitors
(F1) Methyl tris-1,1-dimethyl-2-propynyloxysilane (boiling point = 245°C (1013.25 hPa, amount to be 300 ppm by mass relative for the composition)
(F2) 1-Ethynyl-1-cyclohexanol (in an amount equal to 300 ppm by mass for the composition)
(G) Adhesion-imparting agent
(G1) Bis(trimethoxysilylpropoxymethyl) vinylsilatrane
(G2) Bis(trimethoxysilylpropoxymethyl)allylsilatrane
(G2) Epoxy group-containing polysiloxane represented by the formula:

   (Me₂ViSiO_{1/2})_{0.2}(MeEpSiO_{2/2})_{0.25}(PhSiO_{3/2})_{0.55}(HO_{1/2})_{0.005}

Regarding Examples 1 to 7, 9 to 14, and Comparative Examples 1 to 7, uniform granular white or black curable silicone compositions were prepared according to the following procedure. At the same time, in Example 8, a uniform granular curable silicone composition was prepared by batch feeding all components into a small grinder according to the following procedure. The composition and number of parts of each composition are shown in the table. In addition, the values for softening viscosity, melt viscosity, TS-1, flexural strength, linear expansion coefficient, and die shear for each composition are shown in the table.

### Examples 1 to 7 and 9 to 14, and Comparative Examples 1 to 7

(D) inorganic filler, (H) wax, and (ds) inorganic filler treatment agent were all fed at once into a small pulverizer and stirred at 100°C for 1 minute, the (D) inorganic filler was subjected surface treatment, and the pulverizer temperature was returned to 25°C.

Next, (A) hot-melt silicone component, optional (E) organopolysiloxane compound, (B) SiH siloxane {the amount of silicon atom-bound hydrogen atoms in the (B) component per 1.0 mole of vinyl group in this composition is the number of moles of the SiH/Vi ratio shown in the table}, (F) inhibitor, (G) adhesion agent, and (C) hydrosilylation reaction catalyst were added to a small grinder and stirred at room temperature (25°C) for 1 minute to prepare a uniform granular white or black curable silicone composition.

### Example 8

(A) Hot-melt silicone component, (E) organopolysiloxane compound, (B) SiH siloxane {the amount of silicon atom-bound hydrogen atoms in the (B) component per 1.0 mole of vinyl group in this composition is the number of moles of the SiH/Vi ratio shown in the table}, (F) inhibitor, (G) adhesion promoter, (C) hydrosilylation reaction catalyst, (D) inorganic filler, and (H) wax were fed into a small pulverizer and stirred at room temperature (25°C) for 1 minute to prepare a uniform granular white curable silicone composition.

**Table 3**

| Test No. | Examples | | | | | | | | | |
|---|---|---|---|---|---|---|---|---|---|---|
| Component (g) | 1 | 2 | 3 | 4 | 5 | 6 | 7 | 8 | 9 | 10 |
| A1 Reference Example 9 | 67.4 | | | 55.3 | 54.9 | | | | 55.3 | |
| A2 Reference Example 10 | | 67.4 | | | | 55.8 | | | | |
| A3 Reference Example 11 | | | 67.4 | | | | 55.3 | 55.3 | | |
| A4 Reference Example 12 | | | | | | | | | | |
| A5 Reference Example 13 | | | | | | | | | | |
| A6 Reference Example 14 | | | | | | | | | | |
| A7 Reference Example 15 | | | | | | | | | | |
| A8 Reference Example 16 | | | | | | | | | | 55.8 |
| A9 Reference Example 17 | | | | | | | | | | |
| B1 | 2.7 | 2.7 | 2.7 | 3.2 | 3.4 | 2.9 | 3.2 | 3.2 | 3.2 | 2.9 |
| B2 | 18.5 | 18.5 | 18.5 | 22.5 | 22.7 | 22.3 | 22.5 | 22.5 | 22.5 | 22.3 |
| C1 | 10 ppm | 10 ppm | 10 ppm | 10 ppm | 10 ppm | 10 ppm | 10 ppm | 10 ppm | 10 ppm | |
| D1 | 1350 | 1350 | 1350 | | 1394 | 1394 | | | | 1394 |
| D2 | 150 | 150 | 150 | 155 | 155 | 155 | 155 | 110 | 155 | 155 |
| D3 | | | | 1394 | | | 1394 | 1100 | 1394 | |
| D4 | | | | | | | | | | |
| ds1 | 5.7 | 5.7 | 5.7 | 5.9 | 5.9 | 2.9 | 5.9 | | 5.9 | 5.9 |
| ds2 | | | | | | 3 | | | | |
| E1 | | | | 5.6 | | | 5.6 | 5.6 | 5.6 | |
| E2 | | | | | 5.6 | | | | | |
| E3 | | | | | | 5.6 | | | | 5.6 |
| E'1 | | | | | | | | | | |
| E'2 | | | | | | | | | | |
| F1 | 300 ppm | 300 ppm | 300 ppm | 300 ppm | 300 ppm | 300 ppm | 300 ppm | 300 ppm | | 300 ppm |
| F2 | | | | | | | | | 300 ppm | |
| G1 | 5.7 | | 5.7 | 5.9 | | | 5.9 | 4.7 | | |
| G2 | | 5.7 | | | 5.9 | 5.9 | | | 5.9 | 5.9 |
| G3 | | | | | | | | | | |
| H | 1.6 | 1.6 | 1.6 | 1.7 | 1.7 | 1.7 | 1.7 | 1.3 | 1.7 | 1.7 |
| SiH/Vi | 1.07 | 1.07 | 1.07 | 1.08 | 1.05 | 1.13 | 1.08 | 1.10 | 1.08 | 1.11 |

**Table 4**

| Test No. | Examples | | | | Comparative Examples | | | | | | |
|---|---|---|---|---|---|---|---|---|---|---|---|
| Component (g) | 11 | 12 | 13 | 14 | 1 | 2 | 3 | 4 | 5 | 6 | 7 |
| A1 Reference Example 9 | 55.3 | | | 55.3 | | | | | | | |
| A2 Reference Example 10 | | 55.8 | | | | | | | | | |
| A3 Reference Example 11 | | | | | | | | | | | |
| A4 Reference Example 12 | | | | | 57.2 | | | 62.5 | 57.2 | | 54 |
| A5 Reference Example 13 | | | | | | 63.8 | | | | | |
| A6 Reference Example 14 | | | | | | | 63.8 | | | | |
| A7 Reference Example 15 | | | | | | | | | | 55.5 | |
| A8 Reference Example 16 | | | | | | | | | | | |
| A9 Reference Example 17 | | | 55.8 | | | | | | | | |
| B1 | 22.5 | 2.9 | 2.9 | 3.2 | 2.9 | 1.9 | 1.9 | 2.3 | 2.7 | | 2.0 |
| B2 | 3.0 | 22.3 | 22.3 | 22.5 | 22.3 | 15.0 | 15.0 | 16.0 | 22.1 | 16.0 | 21.0 |
| C1 | 10 ppm | 10 ppm | 10 ppm | 10 ppm | 10 ppm | 10 ppm | 10 ppm | 10 ppm | 10 ppm | 10 ppm | 10 ppm |
| D1 | 1394 | 1394 | 1394 | | 1394 | | 1350 | 1350 | | 1200 | 1400 |
| D2 | 155 | 155 | 155 | 153 | 155 | 150 | 150 | 150 | 150 | 130 | 150 |
| D3 | | | | 1394 | | 1350 | | | 1350 | | |
| D4 | | | | 1.7 | | | | | | | |
| ds1 | 2.9 | 5.9 | 5.9 | 5.9 | 5.7 | 5.7 | 5.7 | 5.7 | 5.7 | 5.7 | 5.7 |
| ds2 | 3 | | | | | | | | | | |
| E1 | 5.6 | | | 5.6 | 5.7 | 6.3 | | | | 5.5 | 5 |
| E2 | | | | | | | | | | | |
| E3 | | 5.6 | 5.6 | | | | 6.3 | | | | |
| E'1 | | | | | | | | 6.2 | | | 5 |
| E'2 | | | | | | | | | 6.0 | | |
| F1 | 300 ppm | 300 ppm | 300 ppm | 300 ppm | 300 ppm | 300 ppm | 300 ppm | 300 ppm | 300 ppm | 300 ppm | 300 ppm |
| F2 | | | | | | | | | | | |
| G1 | | | | 5.9 | | 5.7 | 5.7 | | 5.7 | 5.7 | 5.7 |
| G2 | 5.9 | | 5.9 | | 5.7 | | | 5.7 | | | |
| G3 | | 5.9 | | | | | | | | | |
| H | 1.7 | 1.7 | 1.7 | 1.7 | 1.7 | 1.6 | 1.6 | 1.6 | 1.6 | 1.6 | 1.7 |
| SiH/Vi | 1.02 | 1.12 | 1.12 | 1.08 | 1.12 | 1.07 | 1.07 | 1.08 | 1.21 | 1.10 | 1.09 |

**Table 5**

| | | Examples | | | | | | | | | |
|---|---|---|---|---|---|---|---|---|---|---|---|
| | | 1 | 2 | 3 | 4 | 5 | 6 | 7 | 8 | 9 | 10 |
| Softening temperature [°C] | | 90 | 90 | 90 | 85 | 90 | 90 | 85 | 95 | 85 | 90 |
| Melt viscosity [Pas] | | 82 | 77 | 75 | 14 | 13 | 15 | 12 | 110 | 14 | 13 |
| TS-1 [sec] | Initial | 88 | 91 | 85 | 70 | | 69 | 72 | | 48 | 59 |
| | 40°C After 1 week | 90 | 90 | 83 | 70 | | 70 | 71 | | 3 | 21 |
| Bending strength [MPa] | | 64 | 62 | 59 | 65 | 63 | 58 | 60 | 63 | 65 | 63 |
| Linear expansion coefficient [ppm/°C] | | 13 | 12 | 13 | 12 | | 14 | | | | |
| Die shear strength | To Al [MPa] | 12.1 | 11.8 | 11.5 | 12.2 | 11.8 | | 11.9 | | | 11.9 |
| | To Ni [MPa] | 10.1 | 9.9 | 10.5 | 10.5 | 9.8 | | 10.3 | | | 9.9 |

**Table 6**

| | | Examples | | | | Comparative Examples | | | | | | |
|---|---|---|---|---|---|---|---|---|---|---|---|---|
| | | 11 | 12 | 13 | 14 | 1 | 2 | 3 | 4 | 5 | 6 | 7 |
| Softening temperature [°C] | | 85 | 90 | 90 | 85 | 100 | 70 | 100 | 100 | 85 | 100 | Does not become solid at room temperature |
| Melt viscosity [Pas] | | 11 | 16 | 10 | 15 | 17 | 14 | 28 | 34 | 12 | 30 | |
| TS-1 [sec] | Initial | | 65 | | 73 | 72 | 68 | 230 | | 81 | | |
| | 40°C After 1 week | | 65 | | 75 | 75 | 66 | 240 | | 80 | | |
| Bending strength [MPa] | | 39 | 60 | 65 | 64 | 52 | 45 | 61 | 47 | 43 | 42 | |
| Linear expansion coefficient (ppm/°C) | | | | 14 | 12 | 13 | | | | | | |
| Die shear strength | To Al [MPa] | | 9.9 | 12.7 | | 11.3 | 10.9 | 12.5 | 11.1 | | 11.4 | |
| | To Ni [MPa] | | 0 | 11.2 | | 9.7 | 9.9 | 10.3 | 9.5 | | 9.3 | |

### Summary

The curable silicone compositions in Examples 1 to 14 of the present invention were found to have good hot-melt properties, while their cured products were found to have low linear expansion coefficients and mechanical strength such as bending strength and die shear strength sufficient for practical use. In particular, by adding component (E) to the compositions in Examples 4 to 7 and 9 to 14, a low melt viscosity could be achieved for the compositions without decreasing the strength of the cured products.

From the results of Example 8, the inorganic filler serving as component (D) is preferably treated with a specific treating agent. From the results of Examples 9 and 10, it was found that component (F), which is an optional component, is preferably a specific compound and that component (C) is more preferably a specific catalyst. Further, from the results of Example 11, it was confirmed that use of a combination of specific crosslinking agents is effective as component (B), while from the results of Example 12, it was confirmed that when a specific carbasilatrane compound is used as component (G), adhesive strength is further improved.

At the same time, the composition requirements of the present invention were not satisfied by Comparative Examples 1 to 7, in which component (A) with a specific structure was not used, and the mechanical strength of the resulting cured product could not be sufficiently improved. From the results of Comparative Examples 4 and 5, it was found that it is important to include the R₂SiO_{2/2} unit in the structure of the main component, with no significant increase in strength observed even when a compound containing the unit was added as a separate component. In addition, in Comparative Example 6, a compound was used in which a single R₂SiO_{2/2} unit was included in the main component; however, in this example, a remarkable increase in strength was not observed. This indicates that the R₂SiO_{2/2} unit incorporated into the base resin needs to have a chain siloxane structure consisting of D units, with these units being continuous. Meanwhile, it was found from Comparative Example 7 that when a compound having continuous R₂SiO_{2/2} units and component (E) that has the effect of increasing crosslinking density were used at the same time, the resulting composition lost hot melt properties.

### Manufacturing Example 1

The granular curable silicone composition, such as Example 1 above, was heated to 80°C, heated and melted using a twin-screw extruder, and kneaded in the form of a semi-solid softened material, then fed onto a releasable film (Biwa liner manufactured by Takara Inc.) at a feed rate of 5 kg/hour and laminated between the two releasable films. The laminate was then stretched between rolls to form a laminate in which a hot-melt curable silicone sheet having a thickness of 500 µm is laminated between two releasable films, after which the entire laminate was cooled by a cooling roll set at -15 °C. In said laminate, a flat and homogeneous hot-melt curable silicone sheet was obtained by separating the releasable film.

### Manufacturing Example 2

The granular curable silicone compositions of Example 1 and the like described above were heated to 80°C, melted and kneaded using a twin-screw extruder, and formed into a sheet shape using a T-type die (opening dimensions: 800 µm × 100 mm, heated to 80°C), then fed onto a releasable film (Biwa liner manufactured by Takara Inc.) at a supply speed of 5 kg/hr. The entire sheet was cooled by a cooling roll set at -15°C, then laminated between the two releasable films. The laminate was then stretched between rolls to form a laminate in which a hot-melt curable silicone sheet having a thickness of 500 µm is laminated between two releasable films. In said laminate, a flat and homogeneous hot-melt curable silicone sheet was obtained by separating the releasable film.

## Claims

1. A curable silicone composition comprising: (A) a hot-melt organopolysiloxane resin represented by (R¹₃SiO_{1/2})ₐ(R²₂SiO_{2/2})_{b}(R²SiO_{3/2})_{c}(SiO_{4/2})_{d}(R³O_{1/2)e}
(wherein, each R¹ is independently a monovalent hydrocarbon group having 1 to 10 carbon atoms, provided at least two of all R¹ in a single molecule are an alkenyl group; each R² is independently a monovalent hydrocarbon group having 1 to 10 carbon atoms that is not an alkenyl group; each R³ is a hydrogen atom or an alkyl group having 1 to 10 carbon atoms; and a, b, c, d, and e are numbers satisfying 0.10 ≤ a ≤ 0.40, 0.05 ≤ b ≤ 0.50, 0.30 ≤ c ≤ 0.90, 0 ≤ d ≤ 0.20, and 0 ≤ e ≤ 0.05, provided a + b+ c + d = 1);
(B) an organohydrogenpolysiloxane having at least two silicon-bonded hydrogen atoms per molecule;
(C) a hydrosilylation catalyst in an amount sufficient to effect a hydrosilylation reaction of the reactive silicone composition; and
(D) 400 to 3,000 parts by mass of a functional organic filler with respect to 100 parts by mass of components (A) to (C),
wherein the composition is solid at 25°C and has hot-melt properties at a temperature of 200°C or lower.

2. The curable silicone composition according to claim 1, further comprising, as component (E), an organosiloxane compound containing 10 mass % or more alkenyl groups per molecule represented by
(R¹₃SiO_{1/2})ₐ(R²₂SiO_{2/2})_{b}(R²₂SiO_{3/2})_{c}(SiO_{4/2})_{d}(R³O_{1/2)e}
(wherein, each R¹ is independently a monovalent hydrocarbon group having 1 to 10 carbon atoms, provided at least two of all R¹ in a single molecule are an alkenyl group; each R² is independently a monovalent hydrocarbon group having 1 to 10 carbon atoms that are free of an alkenyl group; each R³ is a hydrogen atom or an alkyl group having 1 to 10 carbon atoms; and a', b', c', d', and e' are numbers satisfying 0.40 ≤ a' ≤ 0.80, 0 ≤ b' ≤ 0.90, 0 ≤ c' ≤ 0.60, 0 ≤ d' ≤ 0.50, and 0 ≤ e' ≤ 0.05, provided a' + b' + c' + d' = 1).

3. The curable silicone composition according to claim 1 or 2, further comprising, as component (F), 1 to 5000 ppm of a curing retarder for a hydrosilylation reaction having a boiling point of 200°C or higher at atmospheric pressure, based on the total mass of the composition.

4. The curable silicone composition according to any one of claims 1 to 3, further comprising, as component (G), at least one type of adhesion-imparting agent selected from among silatrane derivatives and carbasilatrane derivatives.

5. The curable silicone composition according to any one of claims 1 to 4, further comprising, as component (H), an organic wax having a melting point within the range of 30 to 160 °C.

6. The curable silicone composition according to any one of claims 1 to 5, wherein
component (C) is a combination of two types of compounds including a linear organopolysiloxane represented by the general formula:
HR⁴₂SiO(R⁴₂SiO)ₙSiR⁴₂H,
and
(C-2) a branched organopolysiloxane represented by the average unit formula:
(R⁴SiO_{3/2})ₚ(R⁴₂SiO_{2/2})_{q}(HR⁴₂SiO_{1/2})ᵣ(SiO_{4/2})ₛ(XO_{1/2})ₜ
(wherein, R⁴ are the same or different phenyl groups or alkyl groups having 1 to 6 carbon atoms, provided the phenyl group content is within the range of 30 to 70 mol% for all R⁴,
n is within the range of 1 to 50, p is a positive number, q is 0 or a positive number, r is a positive number, s is 0 or a positive number, t is 0 or a positive number, q/p is a number within the range of 0 to 10, r/p is a number within the range of 0.1 to 5, s/(p + q + r + s) is a number within the range of 0 to 0.3, and t/(p + q + r + s) is a number within the range of 0 to 0.4.)
wherein the ratio of (C-1):(C-2) per alkenyl group in the entire composition is within the range of 0.05 to 0.6:0.4 to 0.95.

7. The curable silicone composition according to any one of claims 1 to 6, wherein component (C) comprises platinum-based catalyst-containing thermoplastic resin fine particles having a glass-transition temperature of 80°C or higher in an amount such that the amount of platinum metal in the fine particles is 0.1 to 2,000 ppm by mass relative to the composition.

8. The curable silicone composition according to any of claims 1 to 7, wherein component (D) is treated with a silicone-based surface treatment agent having at least one polysiloxane structure and a hydrolyzable silyl group in the molecule.

9. The curable silicone composition according to any one of claims 1 to 8, wherein curing provides a cured product having an average linear expansion coefficient of 30 ppm/°C or less within the range of 25°C to 200°C.

10. The curable silicone composition according to any one of claims 1 to 9, wherein curing provides a cured product having a bending strength of 15 MPa or more as determined by the method prescribed in JIS K 6911-1995 "General Testing Method for Thermosetting Plastics."

11. The curable silicone composition according to any one of claims 1 to 10, wherein component (D) is a reinforcing filler, a pigment, a thermally conductive filler, an electrically conductive filler, a phosphor, or a mixture of at least two of these.

12. The curable silicone composition according to any one of claims 1 to 11 in the form of a particle, a granule, a pellet, or a sheet.

13. A cured product obtained by curing the curable silicone composition according to any one of claims 1 to 12.

14. A member for a semiconductor device made of the cured product according to claim 13.

15. A semiconductor device comprising the cured product according to claim 13.

16. A method for molding a cured product, comprising at least the following Steps (I) to (III):
(I) a step of heating and melting the curable silicone composition according to any one of claims 1 to 12 at a temperature of 100°C or higher;
(II) a step of injecting the curable silicone composition melted in step (I) into a mold or a step of distributing the curable silicone composition obtained in step (I) in a mold by clamping; and
(III) a step of curing the curable silicone composition injected in step (II).

17. The method for molding a cured product according to claim 16, comprising a coating step for overmolding and underfilling a semiconductor element using the cured product obtained by curing the curable silicone composition according to any one of claims 1 to 12.

18. The method for molding a cured product according to claim 16, comprising a step of covering the surface of the semiconductor substrate on which one or more semiconductor elements have been mounted with a cured product obtained by curing the curable silicone composition according to any one of claims 1 to 12, and overmolding such that the gap between semiconductor elements is filled with the cured product.
